# EUROPÄISCHE PATENTSCHRIFT

(11) **EP 3 735 808 B1**
(45) Veröffentlichungstag und Bekanntmachung des Hinweises auf die Patenterteilung: **01.09.2021**
(21) Anmeldenummer: 19813263.1
(22) Anmeldetag: 26.11.2019
(51) Int. Cl.: G08C 19/00, H05K 7/14

(54) **STEUERUNGSSYSTEM UND VERFAHREN ZUR MONTAGE EINES STEUERUNGSSYSTEMS**
CONTROL SYSTEM AND METHOD FOR ASSEMBLING A CONTROL SYSTEM
SYSTÈME DE COMMANDE ET PROCÉDÉ DE MONTAGE D'UN SYSTÈME DE COMMANDE

(30) Priorität: 26.11.2018 DE 102018129835
(43) Veröffentlichungstag der Anmeldung: 11.11.2020
(73) Patentinhaber: Beckhoff Automation GmbH, 33415 Verl (DE)
(72) Erfinder: BECKHOFF, Hans, 33415 Verl (DE); BUDDE, Torsten, 33335 Gütersloh (DE); SOMMER, Lars, 33813 Oerlinghausen (DE); JOST, Michael, 32694 Dörentrup (DE)
(74) Vertreter: Patentanwaltskanzlei WILHELM & BECK
(86) Internationale Anmeldenummer: PCT/EP2019/082597
(87) Internationale Veröffentlichungsnummer: WO 2020/109310

(56) Entgegenhaltungen:
- DE-A1-102014 111 031
- DE-U1- 20 009 207
- US-A- 3 566 190
- US-A1- 2005 077 069

## Beschreibung

Die Erfindung betrifft ein Steuerungssystem für ein Automatisierungssystem und ein Verfahren zur Montage eines Steuerungssystems.

Die Patentanmeldung beansprucht die Priorität der deutschen Patentanmeldung 10 2018 129 835.8 vom 26. November 2018 mit dem Titel "Steuerungssystem, Kopplermodul und Verfahren zur Montage eines Steuerungssystems", deren Offenbarungsgehalt hiermit durch Rückbezug aufgenommen wird.

In der Automatisierungstechnik werden industrielle Steuerungssysteme zur Anlagen-, Maschinen- und Prozesssteuerung verwendet, beispielsweise um Fertigungsprozesse oder Verpackungsprozesse zu steuern und zu überwachen. Ein industrielles Steuerungssystem weist im Allgemeinen eine Feldebene mit Feldgeräten und eine Steuerebene mit Steuergeräten auf. Als Feldgeräte werden bei der industriellen Prozessautomation unter anderem Aktoren, wie Antriebe oder Ventile, und Messwertgeber, wie Kodierer und Sensoren, eingesetzt.

Die Steuerebene umfasst unter anderem Geräte zur Programmierung, Steuerung, Überwachung und Visualisierung der auszuführenden Prozesse. Hier werden in der Regel speicherprogrammierbare Steuerungen oder Steuerungsrechner, etwa Industrie-PCs, eingesetzt. Ein Steuerungsrechner kann beispielsweise als Prozessleitrechner in einer Fertigungsstraße verwendet werden.

Zur Kommunikation zwischen Steuerebene und Feldebene werden üblicherweise Feldbussysteme eingesetzt, die Kommunikationsdaten über ein Datennetzwerk übertragen. Bei den Kommunikationsdaten kann es sich unter anderem um Steuerbefehle zur Ansteuerung von Feldgeräten oder auch um Messdaten handeln. Die Messdaten können beispielsweise auf Messgrößen basieren, die zuvor von einem Feldgerät erfasst worden sind. Feldbussysteme setzen verschiedene Protokolle zur Datenübertragung ein. Ein mögliches Datenübertragungsprotokoll ist das EtherCAT-Protokoll, welches eine echtzeitfähige Kommunikation über ein Ethernet-Netzwerk ermöglicht und in der Norm IEC 61158 spezifiziert wird. Bei einer Datenübertragung nach dem EtherCAT-Standard werden Datentelegramme zur Übertragung der Kommunikationsdaten verwendet. Die Datentelegramme enthalten Steuerdaten, welche die Verteilung und Verarbeitung der Datentelegramme in dem Feldbussystem regeln, und Nutzdaten, welche unter anderem die Kommunikationsdaten umfassen.

Feldbussysteme können in verschiedenen Netzwerktopologien ausgeführt sein, welche die Anordnung der einzelnen Busteilnehmer innerhalb des Feldbussystems beschreiben. Bei einer Ringtopologie sind alle Busteilnehmer nacheinander in Reihe verbunden. Datenpakete mit den Kommunikationsdaten durchlaufen ausgehend von einem ersten Busteilnehmer der Reihe nach alle anderen Busteilnehmer, welche Kommunikationsdaten mit den Datenpaketen austauschen können. Anschließend werden die Datenpakete wieder an den ersten Busteilnehmer zurückgesendet. Eine Variante der Ringtopologie ist die Linientopologie, welche einen geöffneten Ring darstellt. Nachdem die Datenpakete alle Busteilnehmer der Reihe nach durchlaufen haben, werden die Datenpakete in umgekehrter Richtung über die Busteilnehmer an den ersten Busteilnehmer zurückgesendet. Der erste Busteilnehmer ist in der Regel ein Gerät der Steuerebene, etwa ein Steuerrechner.

Ein echtzeitfähiges Feldbussystem in Linientopologie kann mittels des EtherCAT-Standards realisiert werden, welcher in der Norm IEC 61158 beschrieben wird. Auf der Bitübertragungsschicht kann beim EtherCAT-Standard unter anderem der Ethernet-Standard oder der E-Busstandard, welcher auf Low-Voltage-Differential-Signaling basiert, eingesetzt werden. Bei LVDS handelt es sich um eine leiter- bzw. kabelgebundene Übertragungstechnik, welche differentielle Spannungspegel zur Datenübertragung nutzt und in der Norm ANSI/TIA/EIA-644-1995 spezifiziert ist. Die Datenübertragung basiert bei E-Bussystemen auf einem von einer Konstantstromquelle erzeugten Stromfluss durch eine zweiadrige Übertragungsleitung, wobei binäre Logikwerte durch die Stromflussrichtung repräsentiert werden. Die Impedanz der Übertragungsleitung beträgt in der Regel etwa 100-120 Ohm. Mittels LVDS können Datenraten von mehreren 100 MBit/s oder einigen GBit/s realisiert werden. Zur Datenübertragung der Kommunikationsdaten werden bei einem E-Bussystem Datentelegramme eingesetzt, welche die EtherCAT-Datentelegramme verkapseln.

Die unterschiedlichen, zur Prozesssteuerung eingesetzten Feldgeräte wie Antriebe oder Sensoren verfügen in der Regel nicht über eine eigene, integrierte Schnittstelle zum Feldbus. Sie werden damit nicht direkt über die digitalen Kommunikationsdaten angesteuert, sondern senden oder empfangen digitale oder analoge Feldsignale. Bei den Feldsignalen kann es sich beispielsweise um analoge oder digitale Spannungspegel handeln. Entsprechend verfügen die einzelnen Feldgeräte in der Regel über einen oder mehrere digitale oder analoge Ein- und Ausgänge. Sind die Feldgeräte als Motoren oder Antriebe ausgebildet, können diese auch über geregelte Ströme angesteuert werden, die unter Umständen auch hohe Antriebsleistungen übertragen können.

Zur Umsetzung der Kommunikationsdaten in die Feldsignale werden in der Regel Steuerungsmodule eingesetzt. Die Steuerungsmodule sind sowohl über das Feldbussystem mit den Geräten der Steuerebene verbunden, als auch über Feldsignalleitungen mit den Feldgeräten. Die Steuerungsmodule können als digitale oder analoge Eingangsmodule bzw. als digitale oder analoge Ausgangsmodule ausgebildet sein ausgebildet sein.

Handelt es sich um Ausgangsmodule, so empfangen die Steuerungsmodule Steuerbefehle von den Geräten der Steuerebene als Kommunikationsdaten über das Feldbussystem. Die Ausgangsmodule erzeugen auf Grundlage der Steuerbefehle ausgehende Feldsignale, welche unter anderem aus analogen oder digitalen Spannungssignalen oder geregelten Strömen bestehen können. Die Feldsignale werden über Ausgangsanschlüsse der Steuerungsmodule ausgegeben. Die ausgehenden Feldsignale werden anschließend über die Feldsignalleitungen an die Feldgeräte übertragen. Die ausgehenden Feldsignale können unter anderem der Ansteuerung von Antrieben, Motoren oder Ventilen dienen.

Handelt es sich bei den Steuerungsmodulen um Eingangsmodule, so empfängt das Steuerungsmodul eingehende Feldsignale, welche unter anderem aus analogen oder digitalen Spannungs- oder Stromsignalen bestehen können. Das Eingangsmodul wandelt die Feldsignale in Kommunikationsdaten um, welche etwa gemessene Spannungs- oder Stromwerte repräsentieren können. Anschließend kann das Steuerungsmodul die Kommunikationsdaten über das Feldbussystem an die Geräte der Steuerebene, beispielsweise an einen Steuerungsrechner, übertragen.

Die Steuerungsmodule stellen typischerweise mehrere Anschlüsse für die Feldsignale zur Verfügung. Dabei kann ein Steuerungsmodul nur Anschlüsse einer Art aufweisen, etwa nur Eingangsanschlüsse oder nur Ausgangsanschlüsse bzw. nur digitale oder nur analoge Anschlüsse. Werden für den Betrieb eines Feldgeräts sowohl analoge wie auch digitale Feldsignale benötigt, oder werden für den Betrieb eines Feldgeräts sowohl Ein- als auch Ausgänge benötigt, so werden üblicherweise die entsprechenden Signalleitungen an mehrere unterschiedliche Steuerungsmodule angeschlossen. Die für ein Feldgerät oder für eine Gruppe von Feldgeräten benötigten Signalleitungen von unterschiedlichen Steuerungsmodulen können zu Signalleitungssträngen zusammengefasst werden. Die einzelnen Signalleitungsstränge werden dann zu den verschiedenen Feldgeräten verlegt. Das Zusammenfassen der einzelnen Signalleitungen zu feldgerätespezifischen Signalleitungssträngen wird auch als Signalrangierung bezeichnet.

Aus der DE 20 2014 101 491 U1 ist ein busfähiges aneinanderreihbares Anschluss- und/oder Funktionsmodul zur Steuerung und/oder Überwachung technischer Prozesse mit einem blockartigen Aufbau bekannt.

Aus der US 2005/0077069 A ist ein Schaltschrankmodul-Montagesystem bekannt.

Aus der DE 10 2014 118 389 A ist ein Automatisierungsgerät mit einem Hauptmodul und einem austauschbaren Anschlussmodul bekannt.

Aus der US 6,456,495 B1 ist eine Logiksteuerung, die aus in sich geschlossenen Gerätemodulen besteht, bekannt. Die Gerätemodule sind auf eine DIN-Schiene gesteckt.

Aus DE 10 2014 111 031 A1 ist ein Steuerungssystem mit einer Koppeleinheit und einem Koppelmodul bekannt, wobei das Koppelmodul einen ersten Modulanschluss und eine Modulkodiereinrichtung aufweist. Das Koppelmodul weist einen Koppelanschluss und eine Koppelkodiereinrichtung auf, wobei der erste Modulanschluss den Koppelanschluss der Koppeleinheit kontaktiert. Die Modulkodiereinrichtung ist benachbart zum ersten Modulanschluss angeordnet, wobei die Modulkodiereinrichtung in Verbindung mit der Koppelkodiereinrichtung der Koppeleinheit einen an der Koppeleinheit anschließbaren Typs des Moduls festlegt. Die Koppeleinheit weist eine anwendungsspezifisch individuell für das Steuerungssystem gefertigte Leiterkarte auf, in der die Modulkodiereinrichtung integriert ist.

Nachteilig bei dieser Ausgestaltung des Steuerungssystems ist, dass keine Anbindungsmöglichkeit gegeben ist, um flexibel die Koppeleinheit zu erweitern. Ferner ist bei der offenbarten Ausgestaltung der Koppeleinheit ein Steuermodul über ein Datenkabel mit dem Koppelmodul verbunden. Das Steuerungssystem kann daher nicht vollständig vor Einbau in ein Automatisierungssystem auf Funktionsfähigkeit getestet werden, sodass das Automatisierungssystems zum Einbau für eine längere Zeit stillsteht.

Ein weiteres Steuerungssystem mit einer applikationsspezifischen Koppeleinheit ist beispielsweise auch aus DE 10 2014 111 030 B4 bekannt.

Ferner ist aus DE 200 09 207 U1 eine Einrichtung zur Signalübertragung zwischen einem Automatisierungsgerät und einem Feldgerät mit einer Trägerplatte und daran aufsteckbaren Modulen bekannt.

Ferner ist aus US 3 566 190 A eine Kontrolleinrichtung mit einer Vielzahl von elektrischen Kontrollmodulen bekannt.

Es ist Aufgabe der Erfindung, ein flexibel erweiterbares und schnell in ein Automatisierungssystem einbaubares Steuerungssystem, ein verbessertes Kopplermodul und ein verbessertes Verfahren zur Montage solch eines Steuerungssystems für ein Automatisierungssystem bereitzustellen.

Diese Aufgabe wird mittels eines Steuerungssystems gemäß Patentanspruch 1 und einem Verfahren gemäß Patentanspruch 19 gelöst. Vorteilhafte Ausführungsformen sind in den abhängigen Ansprüchen angegeben.

Ein flexibel erweiterbares Steuerungssystem zur Steuerung eines Automatisierungssystems kann dadurch bereitgestellt werden, dass das Steuerungssystem eine Signalübertragungsplatte, eine Hutschiene, wenigstens eine erste Kontakteinrichtung und wenigstens eine zweite Kontakteinrichtung aufweist, wobei die erste Kontakteinrichtung und die zweite Kontakteinrichtung an der Signalübertragungsplatte versetzt zueinander angeordnet sind und die Signalübertragungsplatte die erste Kontakteinrichtung mit der zweiten Kontakteinrichtung zur Übertragung zumindest von Daten elektrisch verbindet. Die Hutschiene ist mechanisch an der Signalübertragungsplatte befestigt. An der Hutschiene ist ein erstes Kopplermodul mechanisch befestigbar. Die erste Kontakteinrichtung ist ausgebildet, ein Signalverarbeitungsmodul oder ein zweites Kopplermodul elektrisch zu kontaktieren, wobei die erste Kontakteinrichtung mit einem Feldgerät elektrisch verbindbar ist.

Diese Ausgestaltung hat den Vorteil, dass bei Ausgestaltung der Signalübertragungsplatte als applikationsspezifische Leiterkarte das Steuerungssystem flexibel durch das an der Hutschiene anordnenbare erste Kopplermodul und gegebenenfalls durch weitere an der Hutschiene anordnenbaren Module erweiterbar ist. Ferner können durch die direkte Anordnung der Hutschiene an der Signalübertragungsplatte die auf die Signalübertragungsplatte wirkenden Kräfte gering gehalten werden. Dadurch wird eine Durchbiegung der Signalübertragungsplatte im Wesentlichen vermieden.

In einer weiteren Ausführungsform weist die Signalübertragungsplatte eine Leiterplatte auf, wobei die Leiterplatte wenigstens eine Leiterplattenschicht mit einem elektrisch isolierenden Werkstoff aufweist. Das elektrisch isolierende Material weist vorzugsweise einen faserverstärkten Kunststoff auf. Die Leiterplatte weist wenigstens eine auf der Leiterplattenschicht angeordnete Leiterbahnlage aus einem elektrisch leitfähigen Material auf, wobei die Leiterplattenschicht ausgebildet ist, mechanische Kräfte aus der Hutschiene abzustützen und die Leiterbahnlage ausgebildet ist, elektrisch die erste Kontakteinrichtung mit der zweiten Kontakteinrichtung zu verbinden.

In einer weiteren Ausführungsform weist die Leiterplatte mehrere Leiterplattenschichten auf, wobei zwischen den Leiterplattenschichten jeweils eine Leiterbahnlage aus einem elektrisch leitfähigen Material angeordnet ist, wobei die Leiterbahnlage und die Leiterplattenschichten abwechselnd in einem Stapel angeordnet sind. Dadurch wird eine hohe mechanische Steifigkeit und Tragfähigkeit gewährleistet. Ferner können die Kontakteinrichtungen gut elektrisch miteinander verbunden sein.

In einer weiteren Ausführungsform weist das Steuerungssystem ein erstes Kopplermodul mit einem ersten Gehäuse, einer dritten Kontakteinrichtung und einem ersten lösbaren Verbindungsmittel auf, wobei an einer ersten Gehäuserückseite des ersten Gehäuses eine erste Aussparung angeordnet ist, in die die Hutschiene eingreift. Das erste Verbindungsmittel ist mit dem ersten Gehäuse verbunden und ausgebildet, zur zerstörungsfrei reversibel lösbaren Befestigung des ersten Gehäuses an der Hutschiene in die Hutschiene einzugreifen. Die dritte Kontakteinrichtung ist an dem ersten Gehäuse angeordnet und zur Datenübertragung ausgebildet. Dadurch kann das erste Kopplermodul besonders einfach ohne Spezialwerkzeug montiert und demontiert werden. Das Kopplermodul kann beispielsweise Daten unterschiedlichen Telegrammtyps oder unterschiedlicher Signaldarstellung umsetzen. Insbesondere eignet sich das Kopplermodul beispielsweise im Durchlauf von einem ersten Telegrammtyp, einer ersten Signaldarstellung, beispielsweise von Ethernet-10-Base-TX auf einen zweiten Telegrammtyp, eine zweite Signaldarstellung, beispielsweise eine E-Bus-Signaldarstellung, umzusetzen.

Von besonderem Vorteil ist, wenn die dritte Kontakteinrichtung an der ersten Gehäuserückseite versetzt in einer Richtung senkrecht zu einer Längserstreckung der ersten Aussparung zu dem ersten Verbindungsmittel angeordnet ist.

In einer weiteren Ausführungsform weist das erste Kopplermodul an einer ersten Gehäuseseitenfläche des ersten Gehäuses eine erste Datenkontakteinrichtung auf, wobei vorzugsweise die erste Gehäuseseitenfläche senkrecht zu der Signalübertragungsplatte angeordnet ist, wobei die erste Datenkontakteinrichtung mit der dritten Kontakteinrichtung zur Datenübertragung gekoppelt ist.

In einer weiteren Ausführungsform weist das Steuerungssystem einen an der Signalübertragungsplatte angeordneten Energieversorgungsanschluss auf, wobei die Signalübertragungsplatte elektrisch den Energieversorgungsanschluss mit der zweiten Kontakteinrichtung verbindet. Das zweite Kopplermodul kontaktiert elektrisch die zweite Kontakteinrichtung zur Datenübertragung und zur Energieversorgung des zweiten Kopplermoduls. Dadurch kann das zweite Kopplermodul besonders einfach versorgt werden ohne dass weitere Kontakteinrichtungen hierfür notwendig sind. Ferner kann der Energieversorgungsanschluss auch mit der ersten Kontakteinrichtung verbunden sein, sodass über die Signalübertragungsplatte Sensoren und/oder Aktoren mit elektrischer Energie, die vom Versorgungsanschluss bereitgestellt wird, versorgbar sind.

In einer weiteren Ausführungsform weist das erste Kopplermodul an der ersten Gehäuseseitenfläche wenigstens einen ersten Energieversorgungskontakt und wenigstens einen zweiten Energieversorgungskontakt auf, wobei der erste Energieversorgungskontakt mit einem ersten Pol einer Gleichspannungsquelle und der zweite Energieversorgungskontakt mit einem zweiten Pol der Gleichspannungsquelle direkt oder indirekt verbindbar ist, wobei der erste Energieversorgungskontakt mit einem ersten Kontaktelement der dritten Kontakteinrichtung und der zweite Energieversorgungskontakt mit einem zweiten Kontaktelement der dritten Kontakteinrichtung zur Übertragung von Versorgungsenergie an die Signalübertragungsplatte elektrisch verbunden ist. Dadurch kann die Energieversorgung des ersten Kopplermoduls und der Signalübertragungsplatte auf einfache Weise ohne weitere Mittel bereitgestellt werden.

In einer weiteren Ausführungsform ist der erste elektrische Energieversorgungskontakt und/oder der zweite elektrische Energieversorgungskontakt plattenförmig ausgebildet und ragt über die erste Gehäuseseitenfläche heraus. Der erste Energieversorgungskontakt und/oder der zweite Energieversorgungskontakt ist mit einer ersten langen Seite senkrecht zur Signalübertragungsplatte ausgerichtet. Dadurch kann eine Kontaktierung zu einem weiteren Modul durch den ersten und/oder zweiten Energieversorgungskontakt während einer Montage der Module in der Montagebewegung erfolgen.

In einer weiteren Ausführungsform weist die dritte Kontakteinrichtung wenigstens ein drittes Kontaktelement auf, wobei das dritte Kontaktelement zur Datenübertragung mit der ersten Datenkontakteinrichtung gekoppelt ist. Dadurch werden mittels der dritten Kontakteinrichtung sowohl Daten als auch elektrische Energie zur Energieversorgung des ersten Kopplermoduls und/oder des Signalverarbeitungsmoduls übertragen.

Die Signalübertragungsplatte weist auf einer Plattenvorderseite einen ersten Plattenbereich, einen zweiten Plattenbereich und einen dritten Plattenbereich auf, wobei die Plattenbereiche aneinander angrenzend angeordnet sind. Im ersten Plattenbereich ist die Hutschiene angeordnet. Im zweiten Plattenbereich sind mehrere, vorzugsweise identisch zueinander ausgebildete zweite Kontakteinrichtungen und im dritten Plattenbereich sind mehrere, erste Kontakteinrichtungen angeordnet. Diese Ausgestaltung hat den Vorteil, dass das Steuerungssystem mit mehreren Feldgeräten gleichzeitig verbunden sein kann. Ferner können im zweiten Plattenbereich mehrere Signalverarbeitungsmodule angeordnet werden, die in Abhängigkeit von den Feldgeräten bereitgestellten Daten oder zu bearbeitenden Daten verarbeiten können. Dadurch kann das Steuerungssystem besonders einfach an das Automatisierungssystem angepasst werden.

In einer weiteren Ausführungsform weist das Steuerungssystem ein zweites Kopplermodul auf, wobei das zweite Kopplermodul mittels eines Befestigungsmittels mechanisch mit der Signalübertragungsplatte verbunden ist. Das zweite Kopplermodul ist elektrisch mit der dritten Kontakteinrichtung des ersten Kopplermoduls zur Datenübertragung, vorzugsweise mittels eines Datenkabels, verbunden. Mittels der beiden Kopplermodule kann das Steuerungssystem auf einfache Weise zur Ansteuerung weiter Feldgeräte, beispielsweise mit E-Bus-Signaldarstellung, erweitert werden.

In einer weiteren Ausführungsform weist das Steuerungssystem eine an der Signalübertragungsplatte angeordnete vierte Kontakteinrichtung auf, wobei die Signalübertragungsplatte zumindest zur Datenübertragung die vierte Kontakteinrichtung mit der ersten Kontakteinrichtung und/oder der zweiten Kontakteinrichtung elektrisch verbindet. Die vierte Kontakteinrichtung ist benachbart zu der Hutschiene auf einer zur Hutschiene zugewandten Plattenvorderseite der Signalübertragungsplatte angeordnet, wobei die dritte Kontakteinrichtung auf einer zur Signalübertragungsplatte zugewandten Gehäuserückseite des ersten Gehäuses angeordnet ist und die dritte Kontakteinrichtung des ersten Kopplermoduls die vierte Kontakteinrichtung zur Datenübertragung und/oder zur Energieübertragung elektrisch kontaktiert. Dadurch kann beim Aufstecken des ersten Kopplermoduls auf die Hutschiene die elektrische Verbindung zwischen Signalübertragungsplatte und erstem Kopplermodul erstellt werden, sodass in der Montage eine Anzahl von Arbeitsschritten besonders gering ist. Ferner wird in Querrichtung die Anordnung des ersten Kopplermoduls durch die dritte und vierte Kontakteinrichtung definiert festgelegt, sodass eine Positionierung des ersten Kopplermoduls an der Hutschiene besonders einfach erfolgt.

In einer weiteren Ausführungsform weist das Steuerungssystem ein Steuermodul auf, wobei das Steuermodul wenigstens eine Steuereinrichtung zur Durchführung eines Steuerverfahrens, ein die Steuereinrichtung aufnehmendes Steuergehäuse und ein reversibel lösbares weiteres Verbindungsmittel aufweist, wobei das Steuermodul auf der Hutschiene montiert ist, wobei das weitere Verbindungsmittel mit dem Steuergehäuse verbunden und ausgebildet ist, die Hutschiene zur zerstörungsfrei reversiblen lösbaren Befestigung des Steuergehäuses an der Hutschiene bereichsweise zu hintergreifen. Dadurch wird ein besonders kompaktes Steuerungssystem bereitgestellt, das flexibel erweiterbar ist und vorab getestet werden kann, um bei einem späteren Zeitpunkt optimal als gesamte Einheit in das Automatisierungssystem eingebaut zu werden. Das Steuermodul kann dabei beispielsweise als Hutschienen-PC, insbesondere als Industrie-PC integriert in das als Hutschienengehäuse ausgebildete Steuergehäuse, ausgebildet sein. Durch die Ankopplung des Steuermoduls an das erste Kopplermodul kann auf zusätzliche Verlängerungs(-koppel-)module verzichtet werden. Auch kann das Steuermodul um wenigstens ein Klemmenmodul, beispielsweise mit EtherCAT-Klemmen, direkt erweitert werden.

In einer weiteren Ausführungsform weist das Steuergehäuse an einer der ersten Gehäuseseitenfläche des ersten Gehäuses zugewandten ersten Steuergehäuseseitenfläche wenigstens eine erste Nut auf. Das Steuermodul weist wenigstens einen ersten Schlitzkontakt auf, wobei der erste Schlitzkontakt in der ersten Nut angeordnet ist. Die erste Nut ist ausgebildet, den ersten Energieversorgungskontakt in einer Montagebewegung zu führen, wobei der erste Schlitzkontakt den ersten Energieversorgungskontakt des ersten Kopplermoduls zur Energieversorgung des ersten Kopplermoduls kontaktiert. Dadurch kann auf zusätzliche Kontaktierungsschritte zur elektrischen Verbindung des ersten Kopplermoduls mit dem Steuermodul verzichtet werden. Das Steuermodul kann dabei ein integriertes Netzgerät aufweisen, durch das die an den Energieversorgungskontakten benötige Spannung vom Steuermodul für das erste Kopplermodul bereitgestellt werden kann.

In einer weiteren Ausführungsform weist das Steuergehäuse an der ersten Steuergehäuseseitenfläche wenigstens eine zur ersten Nut versetzt angeordnete zweite Nut auf. Die erste Nut und die zweite Nut sind vorzugsweise senkrecht zur Signalübertragungsplatte angeordnet. Ferner weisen die erste Nut und die zweite Nut einen vordefinierten Abstand zueinander auf, wobei der vordefinierte Abstand im Wesentlichen einem Abstand zwischen dem ersten Energieversorgungskontakt und dem zweiten Energieversorgungskontakt entspricht.

In einer weiteren Ausführungsform weist das Steuermodul an der ersten Steuergehäuseseitenfläche eine zweite Datenkontakteinrichtung auf, wobei die zweite Datenkontakteinrichtung korrespondierend zu der ersten Datenkontakteinrichtung des ersten Kopplermoduls ausgebildet ist und mit der ersten Datenkontakteinrichtung elektrisch zur Datenübertragung verbunden ist. Die zweite Datenkontakteinrichtung ist elektrisch mit der Steuereinrichtung zur Verarbeitung von mittels der ersten und zweiten Datenkontakteinrichtungen übertragbaren Daten verbunden.

In einer weiteren Ausführungsform weist das Steuermodul auf einer zur Signalübertragungsplatte abgewandten Steuergehäusevorderseite des Steuergehäuses wenigstens einen Einspeiseanschluss mit wenigstens einem ersten Einspeisekontakt auf, wobei der erste Einspeisekontakt mit einer Energieversorgung elektrisch verbindbar ist. Der erste Schlitzkontakt ist mit dem ersten Einspeisekontakt elektrisch verbunden. Zur Verbindung des ersten Energieeinspeisekontakts mit dem ersten Schlitzkontakt kann das Steuermodul ein internes Netzgerät aufweisen, das die Spannung zwischen dem ersten Einspeisekontakt und dem ersten Schlitzkontakt transformiert. Alternativ kann der erste Energieeinspeisekontakt direkt elektrisch mit dem ersten Schlitzkontakt verbunden sein.

Zur Montage des oben beschriebenen Steuerungssystems werden die Signalübertragungsplatte, das erste Kopplermodul und das Steuermodul bereitgestellt, wobei das erste Kopplermodul in einer ersten Montagebewegung, vorzugsweise senkrecht, zur Signalübertragungsplatte auf die Hutschiene montiert wird und das erste Verbindungsmittel das erste Kopplermodul formschlüssig mit der Hutschiene verbindet, wobei das Steuermodul in einer zweiten Montagebewegung, vorzugsweise senkrecht zur Signalübertragungsplatte, auf die Hutschiene montiert wird und das weitere Verbindungsmittel das Steuergehäuse mit der Hutschiene formschlüssig verbindet. Dadurch kann das Steuerungssystem besonders schnell und ohne Spezialwerkzeug auch außerhalb des Automatisierungssystems montiert werden.

Von besonderem Vorteil ist, wenn die dritte Kontakteinrichtung in die vierte Kontakteinrichtung beim Aufstecken des ersten Kopplermoduls auf die Hutschiene eingesteckt wird.

Nachfolgend wird die Erfindung anhand von Figuren näher erläutert. Dabei zeigen:
- Figur 1: eine Vorderansicht eines Steuerungssystems gemäß einer ersten Ausführungsform;
- Figur 2: eine Vorderansicht auf das in Figur 1 gezeigte Steuerungssystem;
- Figur 3: einen vergrößerten Ausschnitt der in Figur 1 gezeigten Vorderansicht auf das Steuerungssystem;
- Figur 4: eine Vorderansicht auf ein Steuerungssystem gemäß einer zweiten Ausführungsform;
- Figur 5: eine Vorderansicht eines Steuerungssystems gemäß einer dritten Ausführungsform;
- Figur 6: eine perspektivische Rückansicht des in Figur 5 gezeigten Steuerungssystems;
- Figur 7: eine perspektivische Darstellung eines ersten Kopplermoduls des in Figur 5 gezeigten Steuerungssystems;
- Figur 8: eine perspektivische Darstellung mit Blickrichtung von hinten nach vorne auf das in Figur 7 gezeigten ersten Kopplermoduls;
- Figur 9: eine weitere perspektivische Darstellung in den Figuren 7 und 8 gezeigten ersten Kopplermoduls;
- Figur 10: eine perspektivische Darstellung eines in Figur 5 gezeigten Steuermoduls des Steuerungssystems;
- Figur 11: eine perspektivische Darstellung mit Blickrichtung von hinten nach vorne auf das in Figur 10 gezeigte Steuermodul;
- Figur 12: eine Seitenansicht auf das in Figur 5 gezeigte Steuerungssystem;
- Figur 13: eine weitere perspektivische Darstellung mit Blickrichtung von vorne nach hinten auf das in den Figuren 10 und 11 gezeigte Steuermodul;
- Figur 14: eine perspektivische Darstellung auf das in Figur 5 gezeigte Steuerungssystem in einem teilmontieren Zustand nach einem dritten Verfahrensschritt;
- Figur 15: eine perspektivische Darstellung des in Figur 5 gezeigten Steuerungssystems in einem teilmontieren Zustand nach dem vierten Verfahrensschritt;
- Figur 16: eine Vorderansicht auf ein Steuerungssystem gemäß einer vierten Ausführungsform; und
- Figur 17: eine Vorderansicht auf ein Steuerungssystem gemäß einer fünften Ausführungsform.

In den nachfolgenden Figuren wird zum erleichterten Verständnis auf ein Koordinatensystem Bezug genommen. Das Koordinatensystem ist als Rechtssystem ausgebildet und weist eine x-Achse (Längsrichtung), eine y-Achse (Querrichtung) und eine z-Achse (Höhenrichtung) auf.

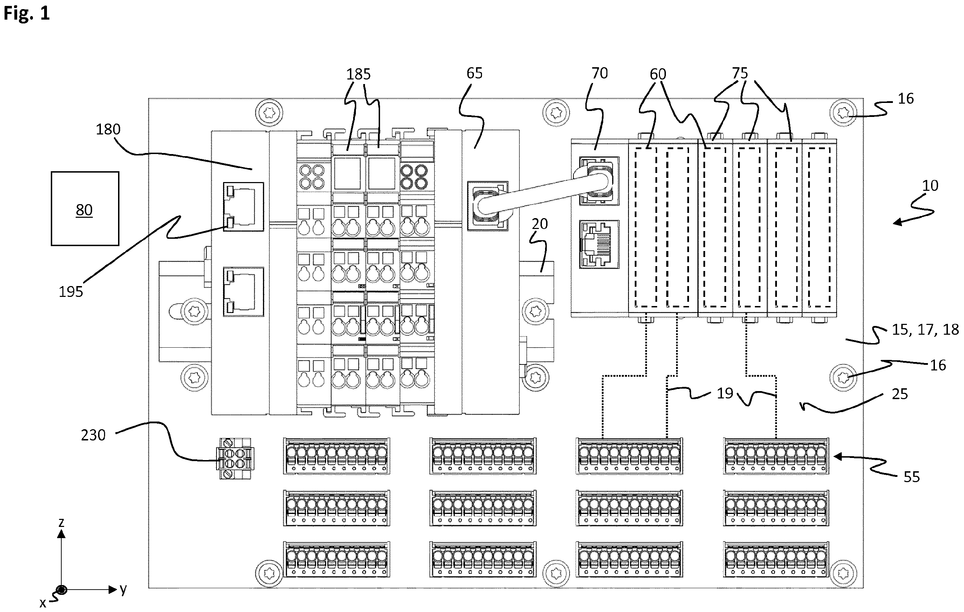

Figur 1 zeigt eine Vorderansicht eines Steuerungssystems 10 gemäß einer ersten Ausführungsform für ein Automatisierungssystem.

Das Steuerungssystem 10 kann Teil des Automatisierungssystems sein und dient zur automatisierten Steuerung von Feldgeräten. Als Feldgeräte werden bei der industriellen Prozessautomation unter anderem Aktoren, wie Antriebe oder Ventile, und Messwertgeber, wie Kodierer und Sensoren, verstanden.

Das Steuerungssystem 10 weist eine Signalübertragungsplatte 15 auf. Die Signalübertragungsplatte 15 kann beispielsweise stehend in einem Schaltschrank des Automatisierungssystems montiert sein. Die Signalübertragungsplatte 15 weist in der Vorderansicht eine beispielhaft rechteckförmige Ausgestaltung auf und ist mittels Verbindungsschrauben 16 mit einer Rückwand (in Figur 1 nicht dargestellt) des Schaltschranks zerstörungsfrei lösbar verbunden. Die Signalübertragungsplatte 15 weist eine deutlich geringere Erstreckung in x-Richtung als in y-Richtung oder in z-Richtung auf.

Die Signalübertragungsplatte 15 umfasst eine Leiterplatte 17, wobei die Leiterplatte 17 wenigstens eine Leiterplattenschicht 18 mit einem elektrisch isolierenden Material, vorzugsweise aus einem glasfaserverstärkten Kunststoff, aufweist. Vorzugsweise weist die Leiterplatte 17 mehrere Leiterplattenschichten 18 auf. Zwischen den Leiterplattenschichten 18 ist zumindest eine Leiterbahnlage 19 (in Figur 1 als punktierte Linie angedeutet) aus einem elektrisch leitfähigen Material angeordnet. Die Leiterbahnlage 19 und die Leiterplattenschichten 18 können abwechselnd in einem Stapel angeordnet sein.

Bevorzugt umfasst die Signalübertragungsplatte 15 vier oder mehr Leiterbahnlagen 19, von denen alle im Inneren der Signalübertragungsplatte 15 angeordnet und beispielsweise einlaminiert sind. Durch den mehrlagigen Aufbau, und vorzugsweise durch die mit Faserverbundwerkstoffen ausgebildeten Leiterplattenschichten 18, ist die Signalübertragungsplatte 15 mechanisch steif ausgebildet. Dadurch kann auf zusätzliche Versteifungselemente, um eine vordefinierte Steifigkeit der Signalübertragungsplatte 15 zu erzielen, an der Signalisierungsplatte 15 verzichtet werden.

Das Steuerungssystem 10 weist ferner wenigstens eine, vorzugsweise mehrere, erste Kontakteinrichtungen 55 und wenigstens eine, vorzugsweise mehrere, zweite Kontakteinrichtungen 60 (in Figur 1 strichliert angedeutet) auf. Die ersten und zweiten Kontakteinrichtungen 55, 60 sind an einer Plattenvorderseite 25 der Signalübertragungsplatte 15 angeordnet und elektrisch mittels der Leiterbahnlage 19 miteinander verbunden.

Des Weiteren weist das Steuerungssystem 10 gemäß der ersten Ausführungsform zusätzlich eine Hutschiene 20, ein erstes Kopplermodul 65, ein zweites Kopplermodul 70, vorzugsweise eine oder mehrere Signalverarbeitungsmodule 75, vorzugsweise ein drittes Kopplermodul 180, vorzugsweise ein oder mehrere Klemmenmodule 185 und ein Steuermodul 80 auf. Das Steuermodul 80 kann über ein in Fig. 1 nicht dargestelltes Datenkabel mit einem zweiten Datenanschluss 195 des dritten Kopplermoduls 180 verbunden sein, um Daten zur Steuerung des Automatisierungssystems zwischen dem Steuermodul 80 und dem dritten Kopplermodul 180 auszutauschen.

Zusätzlich kann an der Signalübertragungsplatte 15 ein Versorgungsanschluss 230 angeordnet sein, wobei die Signalübertragungsplatte 15 den Versorgungsanschluss 230 elektrisch zumindest mit der zweiten Kontakteinrichtung 60 verbindet. Weiterhin kann der Versorgungsanschluss 230 über die Signalübertragungsplatte 15 auch mit den ersten Kontakteinrichtungen 55 elektrisch verbunden sein. Der Versorgungsanschluss 230 kann beispielsweise mit einer Gleichspannungsquelle (nicht dargestellt) elektrisch verbunden sein.

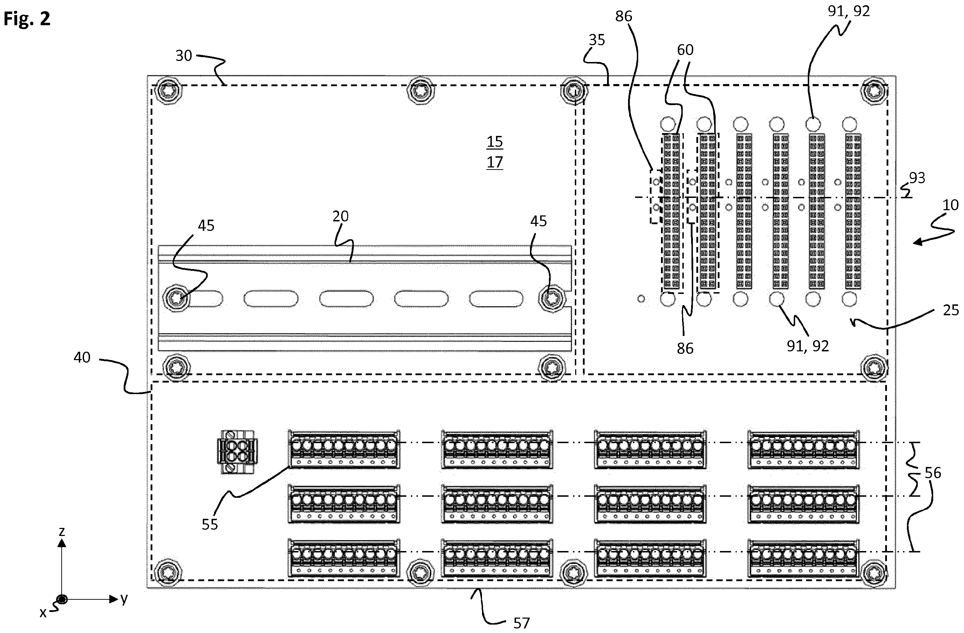

Figur 2 zeigt eine Vorderansicht auf das in Figur 1 gezeigte Steuerungssystem 10. In Figur 2 sind die in Figur 1 gezeigten Baueinheiten erstes Kopplermodul 65, zweites Kopplermodul 70, Signalverarbeitungsmodul 75, Steuermodul 80 und Klemmenmodul 185 aus Übersichtlichkeitsgründen nicht dargestellt.

Die Signalübertragungsplatte 15 ist an der Plattenvorderseite 25 in einen ersten Plattenbereich 30, in einen zweiten Plattenbereich 35 und einen dritten Plattenbereich 40 untergliedert.

Die ersten bis dritten Plattenbereiche 30, 35, 40 stoßen aneinander an. (In Figur 2 sind die Plattenbereiche zur besseren Erkennbarkeit leicht beabstandet zueinander dargestellt). Dabei ist in Figur 2 der erste Plattenbereich 30 linksseitig und oberhalb des dritten Plattenbereichs 40 und der zweite Plattenbereich 35 rechtsseitig des ersten Plattenbereichs 30 und oberhalb des dritten Plattenbereichs 40 beispielhaft angeordnet. Der dritte Plattenbereich 40 erstreckt sich im Wesentlichen über eine gesamte Breite eines unteren Teilbereichs der Signalübertragungsplatte 15.

In dem ersten Plattenbereich 30 weist das Steuerungssystem 10 die Hutschiene 20 auf. Die Hutschiene kann beispielsweise gemäß DIN EN 50022 ausgebildet sein. Die Hutschiene 20 kann in ihrer Haupterstreckungsrichtung parallel zu einer unteren Kante 57 der Signalübertragungsplatte 15 ausgerichtet sein. Die Hutschiene 20 ist mittels einer Schraubverbindung 45, beispielsweise mittels zweier an dem jeweiligen Ende der Hutschiene 20 angeordneten Schrauben, mit der Signalübertragungsplatte 15 mechanisch verbunden. Die Hutschiene 20 kann etwa in dem unteren Drittel des ersten Plattenbereichs 30 angeordnet sein. In Querrichtung, also der y-Richtung erstreckt sich der erste Plattenbereich 30 über etwa zwei Drittel einer Gesamtbreite der Signalübertragungsplatte 15. Im ersten Plattenbereich 30 sind keine erste und/oder zweiten Kontakteinrichtungen 55, 60 angeordnet.

Im dritten Plattenbereich 40 weist das Steuerungssystem 10 wenigstens die erste Kontakteinrichtung 55 auf. Die erste Kontakteinrichtung 55 ist in ihrer Haupterstreckungsrichtung in Querrichtung, also in y-Richtung verlaufend ausgerichtet.

Vorzugsweise sind mehrere in einem Rastermuster angeordnete erste Kontakteinrichtungen 55 angeordnet, wobei die ersten Kontakteinrichtungen 55 jeweils beispielhaft identisch oder unterschiedlich zueinander ausgebildet sind. In der Ausführungsform sind beispielhaft in drei untereinander angeordnete ersten Reihen 56, die parallel zu der unteren Kante 57 des Signalübertragungsplatte 15 verlaufend angeordnet sind, jeweils in Querrichtung versetzt zueinander mehrere erste Kontakteinrichtungen 55 angeordnet. Jeweils zwischen den einzelnen ersten Kontakteinrichtungen 55 ist ein Spalt vorgesehen, um ein Aufschieben einer jeweils an einem ersten Verbindungskabel angeordneten Kabelkontakteinrichtung (nicht dargestellt) auf die erste Kontakteinrichtung 55 zu ermöglichen. Die in Figur 2 gezeigte rasterartige Anordnung, die Ausgestaltung und die Anzahl der ersten Kontakteinrichtungen 55 sind beispielhaft und können je nach Anwendungsfall und Ausgestaltung der Signalübertragungsplatte 15 entsprechend angepasst sein.

Jede der ersten Kontakteinrichtungen 55 kann als Steckkontakt mit mehreren männlichen Kontaktsteckern ausgebildet sein. Die erste Kontakteinrichtung 55 kann mittels des ersten Verbindungskabels mit dem Feldgerät elektrisch verbunden werden. Dabei kann das Feldgerät beispielsweise eine elektrische Maschine, ein Ventil, ein Sensor oder ein Relais sein. Die Ausgestaltung des Sensors ist dabei frei wählbar. Der Sensor dient beispielweise dazu, einen Zustand einer Komponente des Automatisierungssystems zu erfassen.

Das Steuerungssystem 10 weist im zweiten Plattenbereich 35 wenigstens die zweite Kontakteinrichtung 60, vorzugsweise mehrere in Querrichtung, also in y-Richtung nebeneinander angeordnete, zweite Kontakteinrichtungen 60 auf, wobei die zweiten Kontakteinrichtungen 60 identisch zueinander ausgebildet sein können. Dabei kann jede der zweiten Kontakteinrichtungen 60 wenigstens eine, vorzugsweise mehrere in regelmäßigem Abstand angeordnete Durchkontaktierung aufweisen. Eine Haupterstreckungsrichtung der zweiten Kontakteinrichtung 60 verläuft in Höhenrichtung, also in z-Richtung und ist somit beispielhaft geneigt, vorzugsweise senkrecht, zu der Haupterstreckungsrichtung der ersten Kontakteinrichtung 55 angeordnet.

Seitlich in Querrichtung kann neben jeder zweiten Kontakteinrichtung 60 jeweils eine Kodiereinrichtung 86 angeordnet sein, wobei die Kodiereinrichtung 86 in Abhängigkeit zu einer Belegung der zweiten Kontakteinrichtung 60 in der Leiterplatte 17 angeordnete Ausnehmungen aufweist. Die Kodiereinrichtung 86 dient dazu, dass nur jeweils ein an der zweiten Kontakteinrichtung 60 vordefiniertes Signalverarbeitungsmodul oder ein entsprechend der Belegung der zweiten Kontakteinrichtung 60 zugeordnetes zweites Kopplermodul anordenbar ist. Die Kodiereinrichtung 86 verhindert dabei ein Aufstecken eines Signalverarbeitungsmoduls, das nicht die entsprechende Belegung für die zweite Kontakteinrichtung 60 aufweist und somit nicht geeignet ist, an der entsprechenden Position der Signalübertragungsplatte 15 befestigt zu werden.

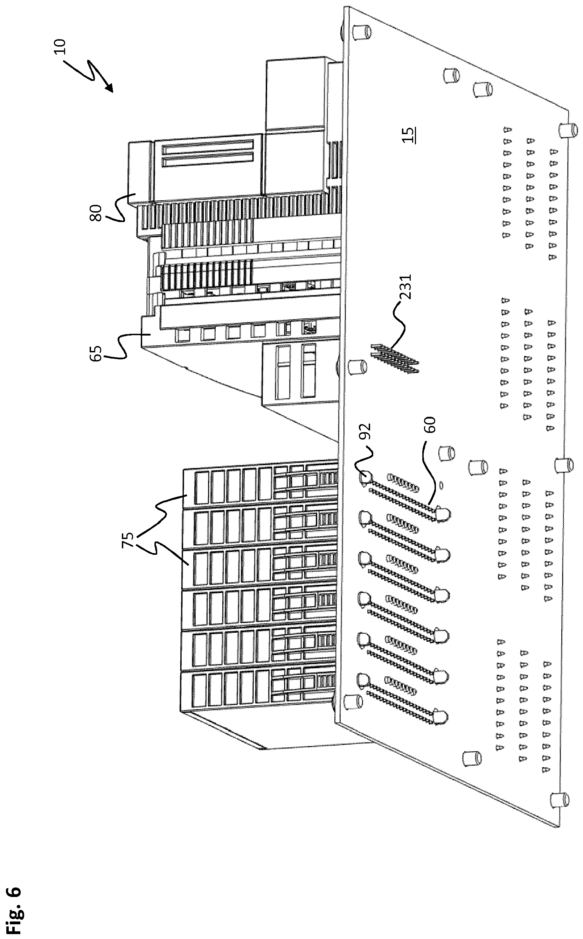

In z-Richtung oberseitig und unterseitig der zweiten Kontakteinrichtung 60 ist jeweils eine Durchgangsöffnung 91 eines Befestigungsmittels 92 angeordnet (beispielsweise auch in Figur 6 zu erkennen), wobei die Durchgangsöffnung 91 in montiertem Zustand des zweiten Kopplermoduls 70 und/oder des Signalverarbeitungsmoduls 75 von einem Rastmittel des Befestigungsmittels 92 durchgriffen und die Signalübertragungsplatte 15 durch das Rastmittel hintergriffen wird, um lösbar das Signalverarbeitungsmodul 75 und/oder das zweite Kopplermodul 70 an der Signalübertragungsplatte 15 formschlüssig zu befestigen.

Die zweiten Kontakteinrichtungen 60 und die Kodiereinrichtungen 86 sind abwechselnd in Figur 2 nebeneinander in Querrichtung, also in y-Richtung parallel zur unteren Kante 57 verlaufend, in einer zweiten Reihe 93 angeordnet. Der Abstand zwischen den einzelnen zweiten Kontakteinrichtungen 60 kann in Abhängigkeit einer Breite des an der jeweiligen zweiten Kontakteinrichtung 60 zu montierenden Signalverarbeitungsmoduls und/oder zweiten Kopplermoduls angepasst sein und gegebenenfalls unterschiedlich zueinander sein. Auch die Anzahl der zweiten Kontakteinrichtungen 60 kann je nach Anwendungsfall entsprechend gewählt sein. Wird mehr als die in Figur 2 gezeigte Anzahl von zweiten Kontakteinrichtungen 60 zum Anschluss von Signalverarbeitungsmodulen benötigt, so kann beispielsweise die Signalübertragungsplatte 15 in Querrichtung gegenüber der in Figur 2 gezeigten Ausgestaltung verlängert ausgebildet sein.

Die Signalübertragungsplatte 15 verteilt Datensignale und eine Spannungsversorgung auf die erste und die zweite Kontakteinrichtung 55, 60 und zwischen den ersten und zweiten Kontakteinrichtungen 55, 60.

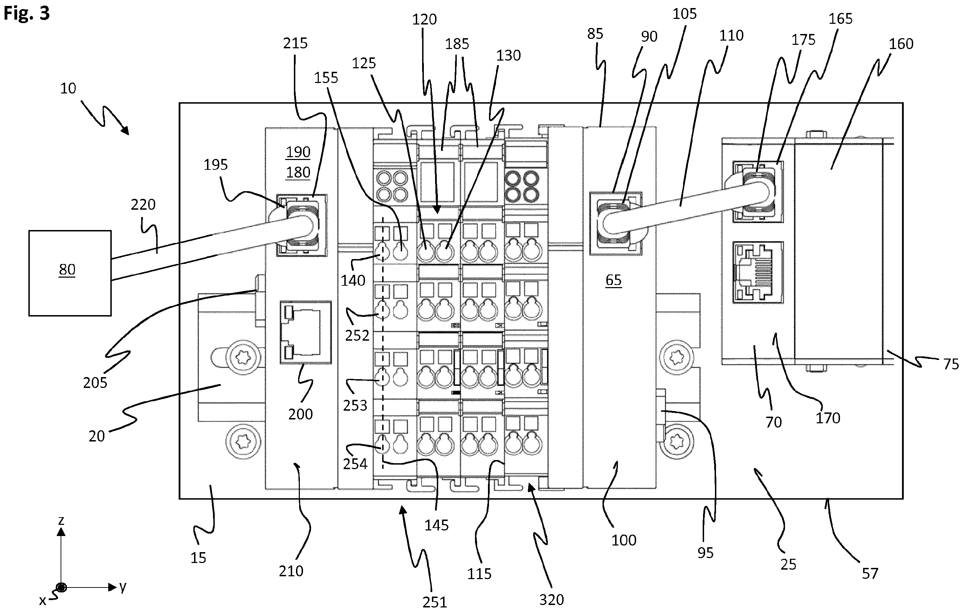

Figur 3 zeigt einen vergrößerten Ausschnitt des ersten Plattenbereichs 30 und einem Teil des an den ersten Plattenbereich 30 in y-Richtung anschließenden zweiten Plattenbereichs 35 der in Figur 1 gezeigten Vorderansicht auf das Steuerungssystem 10.

Das erste Kopplermodul 65 ist auf einer dem in Fig. 2 dargestellten zweiten Plattenbereich 35 zugewandten Seite der Hutschiene 20 angeordnet. Das erste Kopplermodul 65 kann beispielsweise vom Typ eines EK1110 der Beckhoff Automation GmbH & Co. KG sein.

Das erste Kopplermodul 65 weist ein erstes Gehäuse 85, eine dritte Kontakteinrichtung 90 und ein erstes Verbindungsmittel 95 auf. Das erste Verbindungsmittel 95 ist auf einer der Plattenvorderseite 25 zugewandten ersten Gehäuserückseite des ersten Gehäuses 85 im Wesentlichen angeordnet und verbindet zerstörungsfrei reversibel lösbar die Hutschiene 20 mit dem ersten Gehäuse 85.

An einer ersten Gehäusevorderseite 100 des ersten Gehäuses 85 ist beispielhaft die dritte Kontakteinrichtung 90 angeordnet. Die dritte Kontakteinrichtung 90 kann beispielsweise als RJ45-Buchse ausgebildet sein. Die dritte Kontakteinrichtung 90 ist in der Ausführungsform des ersten Kopplermoduls 65 ausschließlich zur Datenübertragung ausgebildet, wobei in Figur 3 in die dritte Kontakteinrichtung 90 ein erster Stecker 105 eines ersten Datenkabels 110 eingesteckt ist.

Zusätzlich kann angrenzend an eine erste Gehäuseseitenfläche 115 des ersten Gehäuses 85 an der ersten Gehäusevorderseite 100 ein Dummy-Feldanschluss 320 angeordnet sein, der keine elektrische Belegung aufweist. Der Dummy-Feldanschluss 320 weist im Wesentlichen die geometrische Ausgestaltung eines Feldanschlusses 120 des Klemmenmoduls 185 auf; er weist jedoch keine elektrische Verbindung zu anderen elektrischen Komponenten auf.

Das zweite Kopplermodul 70 ist linksseitig im in Fig. 2 dargestellten zweiten Plattenbereich 35 angeordnet und weist ein zweites Gehäuse 160 sowie wenigstens einen ersten Datenanschluss 165 auf. Der erste Datenanschluss 165 ist an einer zweiten Gehäusevorderseite 170 des zweiten Gehäuses 160 angeordnet, die auf einer zur Plattenvorderseite 25 abgewandten Seite des zweiten Gehäuses 160 angeordnet ist. Der erste Datenanschluss 165 ist beispielhaft nach Art einer RJ45-Buchse ausgebildet. In montiertem Zustand des Steuerungssystems 10 kontaktiert ein zweiter Stecker 175 des ersten Datenkabels 110 den ersten Datenanschluss 165 und verbindet zur Datenübertragung das erste Kopplermodul 65 mit dem zweiten Kopplermodul 70. Eine Energieübertragung von Versorgungsenergie zwischen der dritten Kontakteinrichtung 90 und dem ersten Datenanschluss 165 erfolgt in diesem Fall nicht.

Rückseitig des zweiten Gehäuses 160 (in Figur 3 verdeckt), auf einer der Plattenvorderseite 25 zugewandten Seite weist das zweite Kopplermodul 70 und jedes der Signalübertragungsmodule 75 jeweils eine weitere Kontakteinrichtung (ebenso in Figur 3 verdeckt) auf, wobei die weitere Kontakteinrichtung korrespondierend zur zweiten Kontakteinrichtung 60 ausgebildet ist und die zweite Kontakteinrichtung 60 elektrisch kontaktiert.

Dabei verbindet die weitere Kontakteinrichtung das zweite Kopplermodul 70 sowohl zur Datenübertragung mit der zweiten Kontakteinrichtung 60 als auch wird über die Signalübertragungsplatte 15 und die zweite Kontakteinrichtung 60 das zweite Kopplermodul 70 mit elektrischer Versorgungsenergie aus der über den Versorgungsanschluss 230 eingespeisten elektrischen Energie versorgt.

Rechtsseitig schließen sich im zweiten Plattenbereich 35 an das zweite Kopplermodul 70 beispielhaft mehrere Signalverarbeitungsmodule 75 an, die jeweils rückseitig ebenso die weitere Kontakteinrichtung aufweisen, die jeweils die zugeordnete zweite Kontakteinrichtung 60 zur Datenübertragung aber auch zur Energieversorgung der jeweiligen Signalverarbeitungsmodule 75 kontaktiert. Aufgrund der vergrößerten Darstellung ist in Fig. 3 nur ein kleiner Abschnitt eines Signalübertragungsmoduls 75 dargestellt.

Zusätzlich weist in der Ausführungsform das Steuerungssystem 10 das drittes Kopplermodul 180 auf, wobei das dritte Kopplermodul 180 in der Ausführungsform linksseitig des ersten Kopplermoduls 65 auf der Hutschiene 20 befestigt ist. In Querrichtung können zwischen dem dritten Kopplermodul 180 und dem ersten Kopplermodul 65 ein oder mehrere Klemmenmodule 185 angeordnet sein, wobei die Anzahl der Klemmenmodule 185 entsprechend der Auslegung des Steuerungssystems 10 gewählt werden kann. Auf die Klemmenmodule 185 kann auch verzichtet werden, sodass das erste Kopplermodul 65 und das dritte Kopplermodul 180 direkt nebeneinander angeordnet sind.

Das dritte Kopplermodul 180 weist ein drittes Gehäuse 190, einen zweiten Datenanschluss 195, vorzugsweise einen dritten Datenanschluss 200 und ein zweites Verbindungsmittel 205 auf. An einer zweiten Gehäuserückseite des dritten Gehäuses 190 verbindet das zweite Verbindungsmittel 205 das dritte Gehäuse 190 zerstörungsfrei reversibel lösbar mit der Hutschiene 20. Dabei kann das dritte Gehäuse 190 auch auf der Plattenvorderseite 25 bereichsweise anliegen, sodass eine Biegebelastung der Signalübertragungsplatte 15 durch aus dem dritten Gehäuse 190 auf die Signalübertragungsplatte 15 wirkenden Kräfte und Momente gering ist.

Der zweite und dritte Datenanschluss 195, 200 sind in Höhenrichtung, also der z-Richtung, versetzt zueinander an einer dritten Gehäusevorderseite 210 des dritten Gehäuses 190 angeordnet. Der zweite und/oder dritte Datenanschluss 195, 200 kann als RJ45-Buchse ausgebildet sein. Dabei kann der zweite Datenanschluss 195 als Eingang eines EtherCAT-Netzwerks und der dritte Datenanschluss 200 als Ausgang zu dem EtherCAT-Netzwerk zur Erweiterung des EtherCAT-Netzwerks ausgebildet sein. In diesem Fall kann der dritte Datenanschluss 200 datentechnisch mit einem weiteren Kopplermodul (nicht dargestellt) verbunden sein.

In montiertem Zustand greift ein dritter Stecker 215 eines zweiten Datenkabels 220 in den zweiten Datenanschluss 195 ein. Das zweite Datenkabel 220 verbindet das dritte Kopplermodul 180 datentechnisch mit dem Steuermodul 80, das in der Ausführungsform beabstandet zu der Signalübertragungsplatte 15, beispielsweise in einem anderen Schrankteil des Schaltschranks angeordnet ist.

Das dritte Kopplermodul 180 kann beispielsweise vom Typ EK1100 der Beckhoff Automation GmbH & Co. KG sein. Zusätzlich weist in der Ausführungsform beispielhaft das dritte Kopplermodul 180 einen Einspeiseanschluss 251 auf.

Der Einspeiseanschluss 251 ist an der dritten Gehäusevorderseite 210 auf einer dem ersten Kopplermodul 65 zugewandten Seite (in Querrichtung) angeordnet. Der Einspeiseanschluss 251 weist wenigstens einen ersten Einspeisekontakt 252 und wenigstens einen zweiten Einspeisekontakt 253 auf. Vorzugsweise weist der Einspeiseanschluss 251 neben dem ersten und zweiten Einspeisekontakt 252, 253 auch einen dritten Einspeisekontakt 254 auf, wobei in der Ausführungsform beispielhaft der erste bis dritte Einspeisekontakt 252, 253, 254 übereinander in einer dritten Reihe 145 angeordnet sind. Die dritte Reihe 145 verläuft beispielhaft senkrecht zur unteren Kante 57 der Signalübertragungsplatte 15. Zusätzlich kann, wie in Figur 3 dargestellt, der erste bis dritte Einspeisekontakt 252, 253, 254 gedoppelt sein, sodass jeweils zwei nebeneinander angeordnete erste bis dritte Einspeisekontakte 252, 253, 254 vorgesehen sind.

Der erste bis dritte Einspeisekontakt 252, 253, 254 können als Klemmkontakt ausgebildet sein. Der erste Einspeisekontakt 252 kann dabei mit einem ersten Pol, insbesondere einem positiven Pol, einer elektrischen Gleichspannungsquelle elektrisch verbunden sein. In Figur 3 ist unterhalb des ersten Einspeisekontakts 252 der zweite Einspeisekontakt 253 angeordnet. Der zweite Einspeisekontakt 253 kann mit einem zweiten Pol, beispielsweise einem negativen Pol der Gleichspannungsquelle verbunden sein. Der dritte Einspeisekontakt 254 ist unterseitig des zweiten Einspeisekontakts 253 angeordnet, wobei der dritte Einspeisekontakt 254 beispielsweise mit einer elektrischen Masse elektrisch verbunden sein kann.

Zusätzlich kann der Einspeiseanschluss 251 oberseitig des ersten Einspeisekontakts 252 einen vierten und fünften Einspeisekontakt 140, 155 aufweisen, wobei der vierte Einspeisekontakt 140 und der fünfte Einspeisekontakt 155 in Querrichtung nebeneinander angeordnet sind und mit einem internen Netzteil des dritten Kopplermoduls 180 verbunden sein können.

In der Ausführungsform sind das erste Kopplermodul 65 und das dritte Kopplermodul 180 mit den zwischen dem ersten und dritten Kopplermodul 180 angeordneten Klemmenmodulen 185 und über die Klemmenmodule 185 datentechnisch verbunden. Dabei ist die Datenverbindung zwischen dem ersten und dritten Kopplermodul 65, 180 durch die Klemmenmodule 185 geschleift.

Das Klemmenmodul 185 kann als Eingangsklemmenmodul und/oder als Ausgangsklemmenmodul ausgebildet sein. Das Klemmenmodul 185 kann beispielsweise vom Typ der EL-Serie der Beckhoff Automation GmbH & Co. KG sein.

Die Ausgestaltung der Klemmenmodule 185 kann je nach Einsatzzweck unterschiedlich sein. So kann das linksseitig in Figur 3 gezeigte Klemmenmodul 185 ein Eingangsklemmenmodul und das rechtsseitig am ersten Kopplermodul 65 angeordnete Klemmenmodul 185 ein Ausgangsklemmenmodul sein. So kann beispielsweise das linksseitige Klemmenmodul 185 vom Typ EL1252 und das rechtsseitige Klemmenmodul 185 vom Typ EL2252 der Beckhoff Automation GmbH & Co. KG sein. Das Klemmenmodul 185 weist einen Feldanschluss 120 mit einem ersten Feldkontakt 125 und einem zweiten Feldkontakt 130 auf, wobei der erste Feldkontakt 125 und der zweite Feldkontakt 130 in Querrichtung beispielhaft nebeneinander angeordnet sind und Klemmen zum Anschluss von jeweils einer Verbindungsleitung ins Feld aufweisen. Das Klemmenmodul 185 erfasst im Betrieb ein Steuersignal aus einer Prozessebene und transportiert es galvanisch getrennt zum übergeordneten Kopplermodul 65, 180. Eine elektrische Energieversorgung des Klemmenmoduls 185 erfolgt über das dritte Kopplermodul 180. Die Ausgestaltung der Klemmenmodule 185 kann sich ferner durch eine Anzahl von Kanälen und einer Anschlussbelegung des Klemmenmoduls 185 am Feldanschluss 120 unterscheiden.

Ist das Klemmenmodul 185 als Ausgangsklemmenmodul ausgebildet, so schaltet das Klemmenmodul 185 Ausgangssignale der Steuerung galvanisch getrennt zur Prozessebene. Der erste Feldkontakt 125 kann dabei als Ausgang ausgebildet sein. Der erste Feldkontakt 125 wird dabei hochgenau passend zum übertragenen Zeitstempel geschaltet, sodass sich Schaltzeitpunkte am Ausgang systemweit exakt vorgeben lassen. Jeder ersten und zweiten Feldkontakt 125, 130 kann einzeln hochohmig geschaltet werden.

In der Ausführungsform setzt das dritte Klemmenmodul 185 beispielsweise die Signaldarstellung im Durchlauf von der Ethernet-100BASE-TX oder EtherCAT auf die E-Bus-Signaldarstellung für das Klemmenmodul 185, das erste und zweite Kopplermodul 65, 70 und die Signalverarbeitungsmodule 75 um.

Das erste Kopplermodul 65 dient als Busendklemme und zur Verlängerung des E-Bus-Bereichs zum zweiten Kopplermodul 70. Das erste Koppelmodul 65 ist dazu mittels des ersten Datenkabels 110 mit dem zweiten Kopplermodul 70 verbunden. Die Energieversorgung des ersten Kopplermoduls 65 erfolgt über die Klemmenmodule 185 vom dritten Kopplermodul 180 aus.

Das zweite Kopplermodul 70 und das zumindest eine Signalverarbeitungsmodul 75 werden rückseitig über die Signalübertragungsplatte 15 mit elektrischer Energie kommend vom Versorgungsanschluss 230 versorgt. Ferner sind das zweite Kopplermodul 70 und das zumindest eine Signalverarbeitungsmodul 75 datentechnisch über die zweiten Kontakteinrichtungen 60 und die Signalübertragungsplatte 15 miteinander verbunden. Das zweite Kopplermodul 70 kann beispielsweise vom Typ EJ1100 der Beckhoff Automation GmbH & Co. KG sein. Das zweite Kopplermodul 70 verbindet datentechnisch die Signalverarbeitungsmodule 75 mit dem ersten Kopplermodul 65.

Durch die Versorgung des zweiten Kopplermoduls 70 und/oder des Signalverarbeitungsmoduls 75 über den Versorgungsanschluss 230 werden über das erste Datenkabel 110 ausschließlich Daten zwischen dem ersten Datenanschluss 165 und der dritten Kontakteinrichtung 90 übertragen.

Das Signalverarbeitungsmodul 75 kann in der Funktionalität identisch zu dem Klemmenmodul 185 ausgebildet sein, wobei das Signalverarbeitungsmodul 75 über die weitere Kontakteinrichtung und die zweite Kontakteinrichtung 60 und die Signalverarbeitungsplatte 15 mit der ersten Kontakteinrichtung 55 verbunden ist. Die erste Kontakteinrichtung 55 übernimmt dabei die Funktion des Feldanschlusses 120 und stellt die elektrische Verbindung zu Feldgeräten bereit.

Das Signalverarbeitungsmodul 75 kann wie auch das Klemmenmodul 185 als Eingangsmodul mit der Funktionalität des Eingangsklemmenmoduls oder als Ausgangsmodul mit der Funktionalität des Ausgangsklemmenmoduls ausgebildet sein. Das Signalverarbeitungsmodul 75 kann beispielsweise vom Typ der EJ-Serie der Beckhoff Automation GmbH & Co. KG sein.

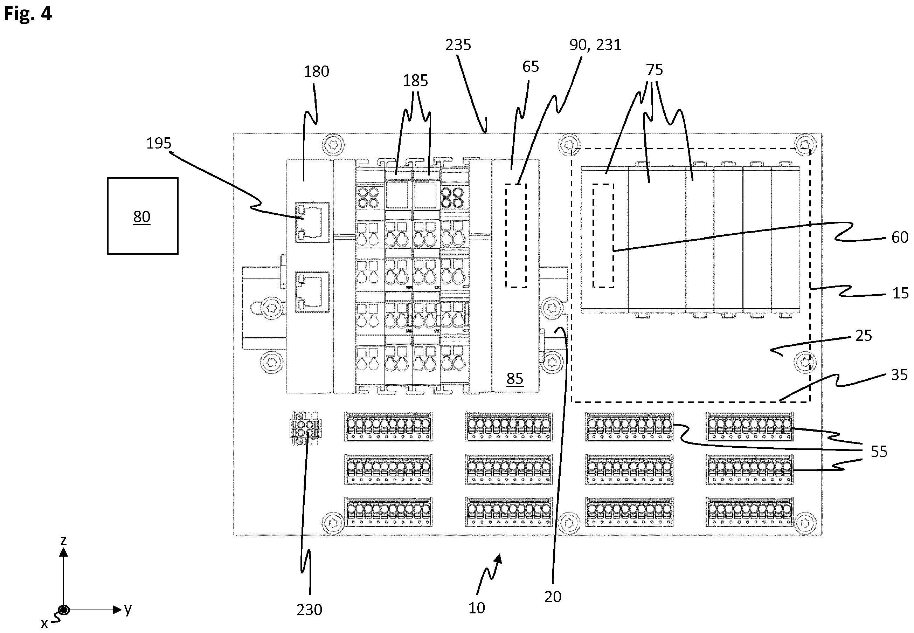

Figur 4 zeigt eine Vorderansicht auf ein Steuerungssystem 10 gemäß einer zweiten Ausführungsform.

Das in Figur 4 gezeigte Steuerungssystem ist im Wesentlichen identisch zu dem in den Figuren 1 bis 3 gezeigten Steuerungssystem 10 ausgebildet. Im Folgenden wird ausschließlich auf die Unterschiede des in Figur 4 gezeigten Steuerungssystems 10 gegenüber dem in den Figuren 1 bis 3 gezeigten Steuerungssystem eingegangen.

Ferner ist das erste Kopplermodul 65 in der Ausführungsform gemäß der Figur 4 eine Kombination aus dem in Figuren 1 bis 3 gezeigten ersten und zweiten Kopplermodul. Dabei wird von dem in Figur 4 gezeigten ersten Kopplermodul 65 die Funktion des in Figuren 1 bis 3 gezeigten zweiten Kopplermoduls 70 mit übernommen, sodass ein Steckplatz, für das in den Figuren 1 bis 3 gezeigte zweite Kopplermodul 70 im zweiten Plattenbereich 35, frei ist und dadurch ein zusätzliches Signalverarbeitungsmodul 75 an den Steckplatz des in Figuren 1 bis 3 gezeigten zweiten Kopplermoduls 70 montiert werden kann.

Das erste Kopplermodul 65 ist dahingehend ferner zusätzlich zu der in Figur 1 bis 3 gezeigten Ausgestaltung abgewandelt, dass die dritte Kontakteinrichtung 90 an der ersten Gehäuserückseite (in Figur 4 verdeckt) versetzt zu dem ersten Verbindungsmittel 95 angeordnet ist.

Ferner weist die Signalübertragungsplatte 15 zusätzlich eine vierte Kontakteinrichtung 231 (in Figur 4 strichliert dargestellt) auf, die an der Plattenvorderseite 25 der Signalübertragungsplatte 15 angeordnet ist. Die dritte Kontakteinrichtung 90 und die vierte Kontakteinrichtung 231 sind korrespondierend zueinander ausgebildet, wobei beispielsweise die dritte Kontakteinrichtung 90 ein oder mehrere in Reihen angeordnete beispielsweise pinförmig ausgebildete Kontaktelemente aufweisen und die vierte Kontakteinrichtung 231 als Durchkontaktierung ausgebildet sein kann. Die dritte Kontakteinrichtung 90 kontaktiert die vierte Kontakteinrichtung 231.

Die vierte Kontakteinrichtung 231 wird durch die Signalübertragungsplatte 15 elektrisch mit der ersten Kontakteinrichtung 55 und/oder mit der zweiten Kontakteinrichtung 60 zumindest zur Datenübertragung elektrisch verbunden. Die vierte Kontakteinrichtung 231 ist benachbart zu der Hutschiene 20 angeordnet. Dabei ist die vierte Kontakteinrichtung 231 in Höhenrichtung zwischen der Hutschiene 20 und einer oberen Plattenkante 235 der Signalübertragungsplatte 15 angeordnet. Vorzugsweise ist dabei die vierte Kontakteinrichtung 231 näher an der Hutschiene 20 als an der oberen Plattenkante 235 angeordnet. Die vierte Kontakteinrichtung 231 weist ihre Haupterstreckungsrichtung in Höhenrichtung, also in z-Richtung auf. Ebenso ist in Figur 4 die Haupterstreckungsrichtung der dritten Kontakteinrichtung 90 in Höhenrichtung, sodass dadurch das erste Kopplermodul 65 in Querrichtung, also in y-Richtung besonders schlank ausgebildet sein kann.

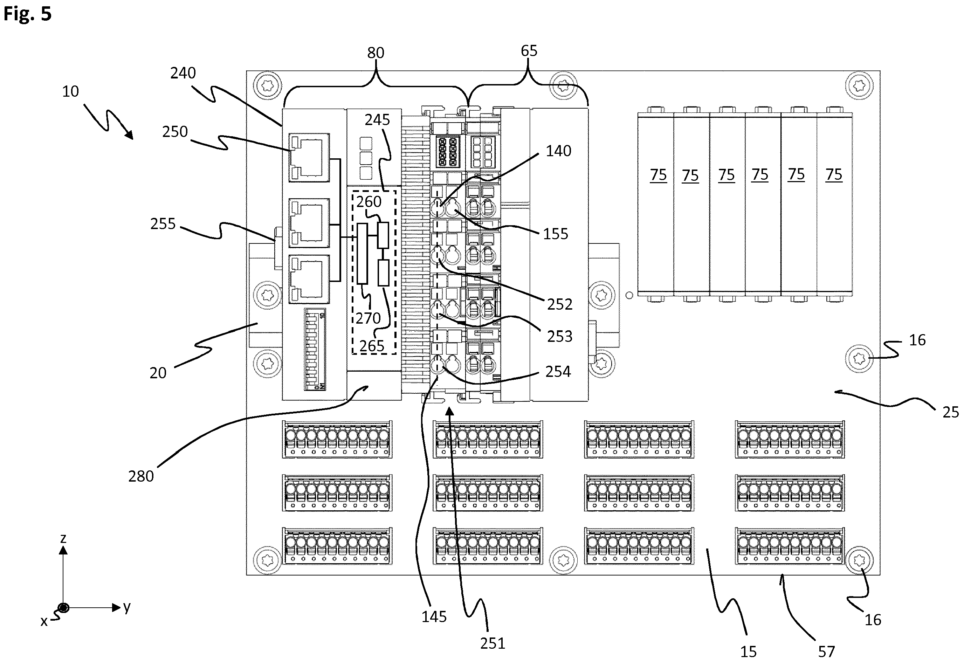

Figur 5 zeigt eine Vorderansicht eines Steuerungssystems 10 gemäß einer dritten Ausführungsform. Figur 6 zeigt eine perspektivische Rückansicht des in Figur 5 gezeigten Steuerungssystems 10.

Das in Figuren 5 und 6 gezeigte Steuerungssystem 10 ist im Wesentlichen identisch zu dem in Figur 4 gezeigten Steuerungssystem 10 ausgebildet. Im Folgenden wird ausschließlich auf die Unterschiede des in den Figuren 5 und 6 gezeigten Steuerungssystems 10 gegenüber dem in Figur 4 gezeigten Steuerungssystem eingegangen.

Anstelle des in Figur 4 gezeigten dritten Kopplermoduls 180 ist das Steuermodul 80 im ersten Plattenbereich angeordnet.

Das Steuermodul 80 weist ein Steuergehäuse 240, eine in dem Steuergehäuse 240 eingeschlossene Steuereinrichtung 245, wenigstens einen vierten Datenanschluss 250, den Einspeiseanschluss 251 und wenigstens ein drittes Verbindungsmittel 255 (in den Ansprüchen auch als weiteres Verbindungsmittel 255 bezeichnet) auf.

Das Steuergehäuse 240 ist mittels des dritten Verbindungsmittels 255 mit der Hutschiene 20 reversibel und zerstörungsfrei lösbar verbunden. Ferner liegt an einer Steuergehäuserückseite das Steuergehäuse 240 an der Plattenvorderseite 25 der Signalübertragungsplatte 15 bereichsweise an. Die Signalübertragungsplatte 15 ist dabei derartig steif durch den Stapel von laminierten Leiterplattenschichten ausgebildet, dass die Signalübertragungsplatte 15 alle Kräfte aus der Hutschiene 20 an dem Schaltschrank über die Schrauben 16 abstützt. Die Steifigkeit der Signalübertragungsplatte 15 kann durch die Anzahl und/oder Dicke der Leiterplattenschichten definiert ausgebildet sein, sodass im Wesentlichen auch bei Anordnung des Steuermoduls 80, zahlreicher Klemmenmodule und des ersten Kopplermoduls 65 eine Biegung oder Krümmung der Signalübertragungsplatte 15 vermieden ist und auch in montiertem Zustand des Steuermoduls 80 die Signalübertragungsplatte 15 sich im Wesentlichen in einer yz-Ebene erstreckt. Dadurch ist eine sichere Befestigung des ersten Kopplermoduls 65 an der Hutschiene 20 und der Signalverarbeitungsmodule 75 an der Signalübertragungsplatte 15 gewährleistet.

Das Steuermodul 80 kann als Embedded-PC ausgebildet sein und die Steuereinrichtung 245 weist einen Datenspeicher 265, eine Recheneinrichtung 260 und eine oder mehrere Schnittstellen 270 auf, wobei die Schnittstelle 270 datentechnisch mit dem vierten Datenanschluss 250 verbunden ist. Im Datenspeicher 265 kann beispielsweise ein vordefinierter Algorithmus, beispielsweise ein Computerprogramm, abgespeichert sein, auf dessen Grundlage die Recheneinrichtung 260 wenigstens ein Steuersignal erfasst, auswertet und/oder ermittelt und in Verbindung mit den über das Feldgerät gelieferten Daten zumindest eines der Feldgeräte steuert. Über den vierten Datenanschluss 250 kann das Steuermodul 80 in ein Netzwerk eingebunden sein.

Der Einspeiseanschluss 251 ist identisch zu dem in Figur 3 erläutertem Einspeiseanschluss 251 des dritten Kopplermoduls 180 ausgebildet sein.

Beispielhaft wird in Figur 5 auf die Anordnung von Klemmenmodulen 185 verzichtet, sodass direkt angrenzend an das Steuermodul 80 das erste Kopplermodul 65 in Figur 5 rechtsseitig des Steuermoduls 80 angeordnet ist. Das erste Kopplermodul 65 ist sowohl datentechnisch als auch zur Energieversorgung mit dem Steuermodul 80 elektrisch verbunden. Durch die Anordnung des Steuermoduls 80 auf der Signalübertragungsplatte 15 und durch die lösbare Befestigung mittels des dritten Verbindungsmittels 255 an der Hutschiene 20 kann das Steuermodul 80 besonders schnell und einfach montiert werden. Ferner ist dadurch das Steuerungssystem 10 auf besonders geringem Bauraum angeordnet.

Des Weiteren kann das Steuersystem 10 und das auf dem Datenspeicher 265 abgelegte Steuerprogramm vor dem Einbau in das Automatisierungssystem vollständig überprüft werden, sodass eine Funktionssicherheit des Steuersystems 10 beim Einbau sichergestellt ist. Dadurch kann eine Stillstandszeit des Automatisierungssystems zum Einbau des Steuerungssystems 10 geringgehalten werden. Ferner ist der mechanische Montageaufwand durch die Anordnung des Steuermoduls 80 an der Signalübertragungsplatte 15 gering.

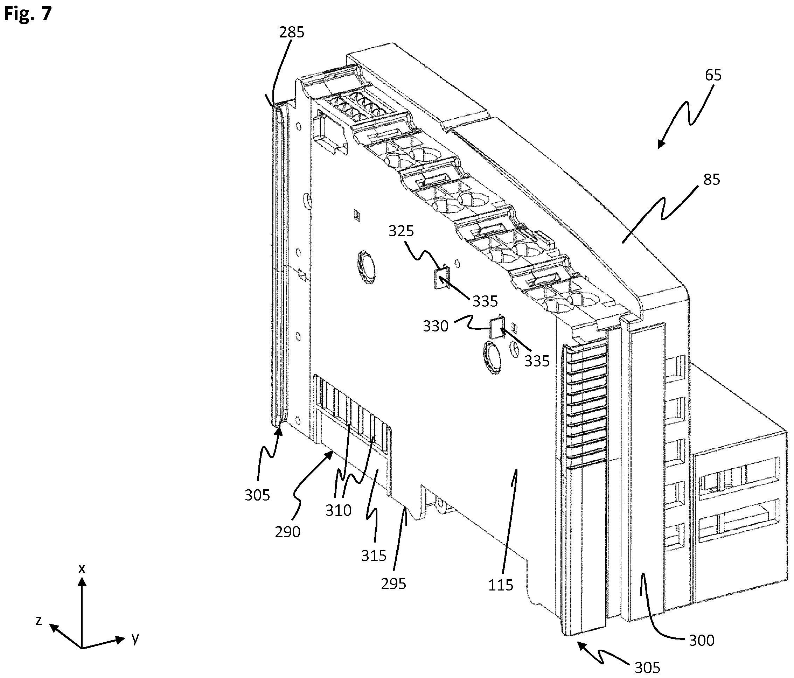

Figur 7 zeigt eine perspektivische Darstellung des ersten Kopplermoduls 65 des in Figur 5 gezeigten Steuersystems 10.

Das erste Kopplermodul 65 weist an der ersten Gehäuseseitenfläche 115, die in der Ausführungsform in montiertem Zustand senkrecht zu der Plattenvorderseite angeordnet ist, eine erste Datenkontakteinrichtung 290 auf. Die erste Datenkontakteinrichtung 290 ist im Wesentlichen angrenzend an eine Gehäuserückseite 295 angeordnet. Die erste Datenkontakteinrichtung 290 ist bezogen auf die im Wesentlichen plan ausgebildete erste Gehäuseseitenfläche 115 in Querrichtung zurückversetzt angeordnet. Dabei ist die erste Datenkontakteinrichtung 290 näher an der Gehäuseoberseite 285 angeordnet als zu einer Gehäuseunterseite 300.

Zusätzlich kann das erste Gehäuse 85 seitlich angrenzend zwischen der Gehäuseoberseite 285 beziehungsweise der Gehäuseunterseite 300 und der ersten Gehäuseseitenfläche 115 jeweils einen Umgreifungsabschnitt 305 aufweisen, wobei der Umgreifungsabschnitt 305 L-förmig ausgebildet ist und sich an einem freien Ende zur jeweils gegenüberliegenden Gehäuseoberseite 285 oder zur Gehäuseunterseite 300 hin erstreckt. Der Umgreifungsabschnitt 305 umgreift in montiertem Zustand eine linksseitig des ersten Kopplermoduls 65 angeordnete Feder des nächsten Moduls, beispielsweise des Steuermoduls oder des Klemmenmoduls, und verbindet formschlüssig das nächste Modul mit dem ersten Kopplermodul 65. Dadurch können die Module in einer Baugruppe auf die Hutschiene 20 aufgesetzt werden und mittels des ersten und dritten Verbindungsmittels an der Hutschiene 20 befestigt werden. Ferner wird dadurch ein ungewolltes Lösen der einzelnen Module in Querrichtung verhindert.

Die erste Datenkontakteinrichtung 290 weist wenigstens einen ersten Datenkontakt 310 auf, wobei der erste Datenkontakt 310 plattenförmig ausgebildet ist und beabstandet zu der Gehäuserückseite 295 angeordnet ist. Der erste Datenkontakt 310 ist unbeweglich und im Wesentlichen steif mit dem ersten Gehäuse 85 verbunden. Dabei kann in der ersten Gehäuseseitenfläche 115 zur Ausbildung der ersten Datenkontakteinrichtung 290 eine Einbuchtung 315 angeordnet sein, wobei an einem Grund der Einbuchtung 315 jeweils der erste Datenkontakt 310 angeordnet ist, der dann über den Grund der Einbuchtung 315 herausragt. Vorzugsweise sind mehrere in Höhenrichtung, also der z-Richtung, beabstandet zueinander angeordnete erste Datenkontakte 310 angeordnet. Die erste Datenkontakteinrichtung 290 ist datentechnisch mit der in Figur 7 nicht dargestellten dritten Kontakteinrichtung 90 verbunden.

Ferner weist das erste Kopplermodul 65 an der ersten Gehäuseseitenfläche 115 wenigstens einen ersten Energieversorgungskontakt 325 und einen in Höhenrichtung zu dem ersten Energieversorgungskontakt 325 angeordneten zweiten Energieversorgungskontakt 330 auf. Der erste Energieversorgungskontakt 325 und der zweite Energieversorgungskontakt 330 können plattenförmig und identisch zueinander ausgebildet sein und ragen über die erste Gehäuseseitenfläche 115 heraus. Der erste Energieversorgungskontakt 325 und der zweite Energieversorgungskontakt 330 sind parallel zueinander ausgerichtet. Dabei ist die Ausrichtung derart gewählt, dass eine lange Seite 335 des ersten und zweiten Energieversorgungskontakts 325, 330, an der der Energieversorgungskontakt 325, 330 die größte Fläche aufweist, parallel zur x-Achse und senkrecht zur ersten Gehäuseseitenfläche 115 ausgerichtet sind.

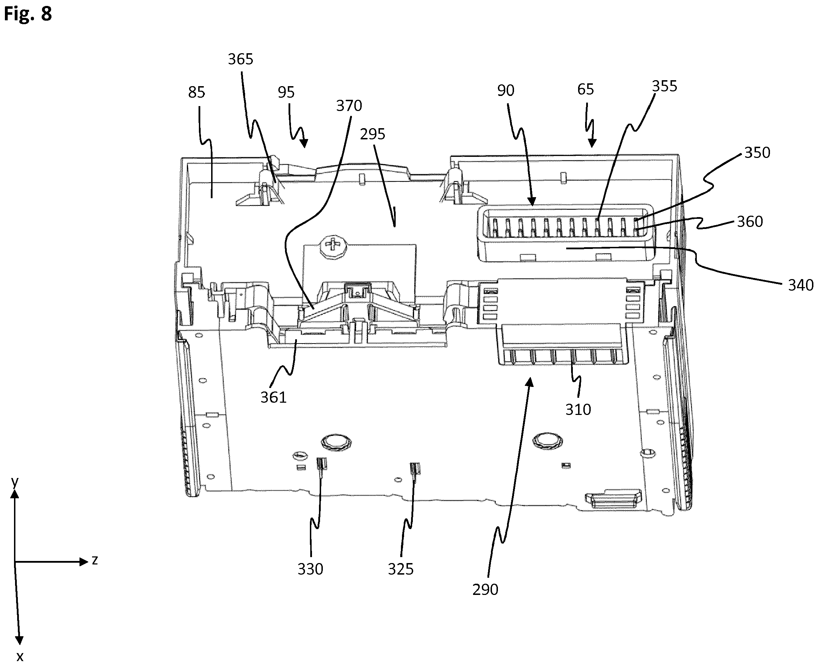

Figur 8 zeigt eine perspektivische Darstellung des in Figur 7 gezeigten ersten Kopplermoduls 65 mit Blickrichtung von hinten nach vorne auf das gezeigte erste Kopplermodul 65.

An der Gehäuserückseite 295 ist die dritte Kontakteinrichtung 90 angeordnet. Die dritte Kontakteinrichtung 90 weist am ersten Gehäuse 85 einen Rahmen 340 auf, der in einer Draufsicht rechteckförmig ausgebildet ist, wobei sich eine Haupterstreckungsrichtung des Rahmens 340 im Wesentlichen in Höhenrichtung erstreckt.

Die dritte Kontakteinrichtung 90 ist beispielhaft mehrreihig ausgebildet und weist in zwei Reihen angeordnete, beispielhaft pinförmig ausgebildete erste bis dritte Kontaktelemente 350, 360, 355 auf, die in montiertem Zustand die Durchkontaktierung der vierten Kontakteinrichtung 231 durchgreifen und dadurch eine elektrische Verbindung zwischen dem ersten Kopplermodul 65 und der Signalübertragungsplatte 15 erzielen. In Höhenrichtung ist die dritte Kontakteinrichtung 90 in etwa auf Höhe der ersten Datenkontakteinrichtung 290 angeordnet. Die dritte Kontakteinrichtung 90 weist wenigstens ein erstes Kontaktelement 350, ein in Querrichtung neben dem ersten Kontaktelement 350 angeordnetes zweites Kontaktelement 360 und wenigstens ein drittes Kontaktelement 355 auf. Vorzugsweise weist, wie in Figur 8 gezeigt, die dritte Kontakteinrichtung 90 zwei Reihen mit jeweils zwölf ersten bis dritten Kontaktelementen 350, 360, 355 auf. Dabei ist die Belegung beispielhaft und kann selbstverständlich angepasst an den Anwendungsfall sein.

Ein erstes Kontaktelement 350 der dritten Kontakteinrichtung 90 ist in der Ausführungsform elektrisch mit dem ersten Energieversorgungskontakt 325 verbunden. Der zweite Energieversorgungskontakt 330 ist elektrisch mit dem zweiten Kontaktelement 360 der dritten Kontakteinrichtung 90 verbunden. Der erste Datenkontakt 310 ist mit dem dritten Kontaktelement 355 datentechnisch verbunden. Dabei sind, wie in der Ausführungsform gezeigt, sechs in Höhenrichtung beabstandet zueinander angeordnete erste Datenkontakte 310 vorgesehen, wobei für jeden ersten Datenkontakt 310 jeweils ein drittes Kontaktelement 355 an der dritten Kontakteinrichtung 90 vorgesehen ist. Diese Ausgestaltung hat den Vorteil, dass über das erste Kopplermodul 65 elektrische Energie zum Betrieb der Signalverarbeitungsmodule 75 in die Signalübertragungsplatte 15 eingespeist werden kann und Daten über die Signalübertragungsplatte 15 zwischen dem ersten Kopplermodul 65 und den Signalverarbeitungsmodulen 75 ausgetauscht werden können.

An der ersten Gehäuserückseite 295 ist versetzt zu der dritten Kontakteinrichtung 90 eine erste Aussparung 361 angeordnet, in der die Hutschiene 20 in montiertem Zustand angeordnet ist. Die erste Aussparung 361 ist nutförmig ausgebildet und entspricht in ihrer Erstreckung in x- und z-Richtung im Wesentlichen einer Erstreckung der Hutschiene 20.

Ferner ist an der ersten Gehäuserückseite 295 das erste Verbindungsmittel 95 angeordnet, wobei das erste Verbindungsmittel 95 erste Haltefedern 365 aufweist, die beidseitig an der Hutschiene anliegen, um das erste Gehäuse 85 an der Hutschiene zu befestigen. Das erste Verbindungsmittel 95 weist ferner ein erstes Eingriffselement 370 auf, das mittig in die Hutschiene eingreift und V-förmig ausgebildet ist. Dadurch ist das erste Gehäuse 85 spielfrei an der Hutschiene 20 befestigt.

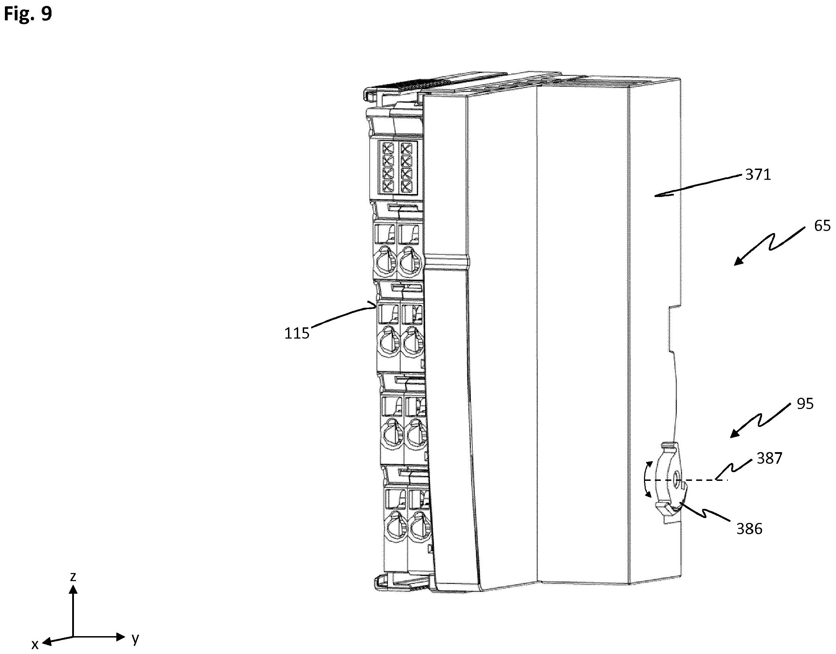

Figur 9 zeigt eine perspektivische Darstellung des in den Figuren 7 und 8 gezeigten ersten Kopplermoduls 65.

An einer zu der ersten Gehäuseseitenfläche 115 gegenüberliegend angeordneten zweiten Gehäuseseitenfläche 371, die parallel zur ersten Gehäuseseitenfläche 115 verläuft, weist das erste Verbindungsmittel 95 einen ersten Drehknopf 386 auf, der drehbar um eine erste Drehachse 387 gelagert ist. Der erste Drehknopf 386 ist zwischen einer ersten Entriegelungsposition und einer ersten Verriegelungsposition verdrehbar, wobei in montiertem Zustand des ersten Kopplermoduls 65 an der Hutschiene in der ersten Entriegelungsposition des Drehknopfs 386 das erste Kopplermodul 65 von der Hutschiene entfernbar ist und/oder aufsteckbar ist. In der ersten Verriegelungsposition hintergreift der erste Drehknopf 386 die Hutschiene bereichsweise und verhindert ein Abziehen des ersten Kopplermoduls 65 von der Hutschiene. Ferner wird ein ungewolltes Abfallen des ersten Kopplermoduls 65 von der Hutschiene ebenso verhindert. Des Weiteren wird dadurch eine zuverlässige Kontaktierung der vierten Kontakteinrichtung durch die dritte Kontakteinrichtung sichergestellt.

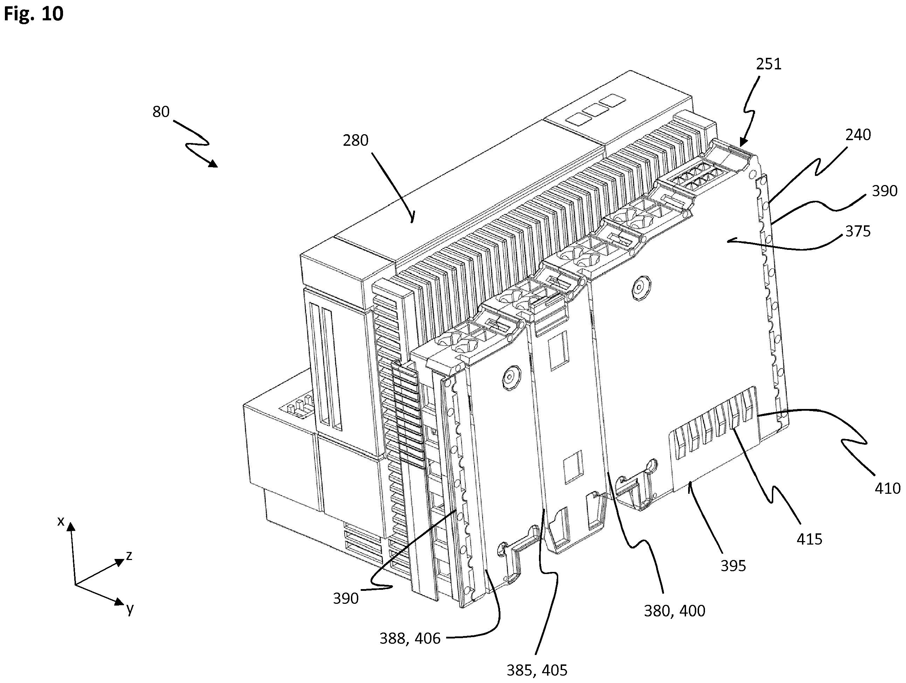

Figur 10 zeigt eine perspektivische Darstellung des in Figur 5 gezeigten Steuermoduls 80.

Eine erste Steuergehäuseseitenfläche 375 des Steuergehäuses 240 ist im Wesentlichen plan ausgebildet und ist im montierten Zustand des Steuermoduls 80 an der Hutschiene 20 im Wesentlichen senkrecht zur Plattenvorderseite 25 der Signalübertragungsplatte 15 ausgerichtet. Dabei liegt die erste Steuergehäuseseitenfläche 375 an der ersten Gehäuseseitenfläche 115 des ersten Kopplermoduls oder dem Klemmenmodul 185 seitlich an. An die erste Steuergehäuseseitenfläche 375 schließt sich an der Steuergehäusevorderseite 280 beispielhaft der Einspeiseanschluss 251 an.

Das Steuergehäuse 240 weist an der ersten Steuergehäuseseitenfläche 375 wenigstens eine erste Nut 380 und eine in Höhenrichtung versetzt zu der ersten Nut 380 angeordnete zweite Nut 385 auf. Zusätzlich kann eine dritte Nut 388 in der ersten Steuergehäuseseitenfläche 375 angeordnet sein, die parallel zu der ersten und/oder zweiten Nut 380, 385 verläuft. Die erste bis dritte Nut 380, 385, 388 erstrecken sich im Wesentlichen von der Steuergehäusevorderseite 280 hin zu einer Steuergehäuserückseite 395. Das Steuermodul 80 weist einen in der ersten Nut 380 angeordneten ersten Schlitzkontakt 400, einen in der zweiten Nut 385 angeordneten zweiten Schlitzkontakt 405 und einen in der dritten Nut 388 angeordneten dritten Schlitzkontakt 406 auf.

Der Abstand der ersten und zweiten Nuten 380, 385 entspricht einem Abstand zwischen dem ersten Energieversorgungskontakt 325 und dem zweiten Energieversorgungskontakt 330.

Greift der erste Energieversorgungskontakt 325 in den ersten Schlitzkontakt 400 ein, kontaktiert dieser den ersten Schlitzkontakt 400. Ebenso kontaktiert in montiertem Zustand des ersten Kopplermoduls oder des Klemmenmoduls 185 an der Hutschiene 20 der zweite Energieversorgungskontakt 330 den zweiten Schlitzkontakt 405. Die ersten und zweiten Schlitzkontakte 400, 405 sind elektrisch mit der Ausgangsseite des internen Netzgeräts verbunden, sodass dadurch die elektrische Energieversorgung des Steuermoduls 80 und des Klemmenmoduls sichergestellt ist. Auch können der erste und zweite Einspeisekontakt 252, 253 direkt elektrisch mit dem ersten und zweiten Schlitzkontakt 400, 405 elektrisch verbunden sein. Ferner wird das erste Kopplermodul durch den Eingriff der ersten und zweiten Energieversorgungskontakte 325, 330 in die ersten und zweiten Schlitzkontakte 400, 405 elektrisch mit Energie versorgt.

Das Steuermodul 80 weist an der ersten Steuergehäuseseitenfläche 375 eine zweite Datenkontakteinrichtung 410 auf, wobei die zweite Datenkontakteinrichtung 410 korrespondierend zu der ersten Datenkontakteinrichtung des ersten Kopplermoduls ausgebildet ist. Die zweite Datenkontakteinrichtung 410 weist korrespondierend zu der Anordnung und der Anzahl von ersten Datenkontakten jeweils einen zweiten Datenkontakt 415 auf, wobei in Querrichtung gegenüberliegend in montiertem Zustand am ersten Datenkontakt jeweils der zweite Datenkontakt 415 anliegt und dadurch die erste Datenkontakteinrichtung durch die zweite Datenkontakteinrichtung 410 kontaktiert ist. Der zweite Datenkontakt 415 kann beispielsweise eine Kontaktfeder aufweisen, die in Querrichtung beispielsweise verschwenkbar ist. Dadurch wird ein zuverlässiger Kontakt des zweiten Datenkontakts 415 am ersten Datenkontakt sichergestellt.

Zur Befestigung in Querrichtung umgreift der Umgreifungsabschnitt 305 die Feder 390, die sich nach außen weg erstreckt und oberseitig und unterseitig am Steuergehäuse 240 angeordnet bzw. ausgebildet ist.

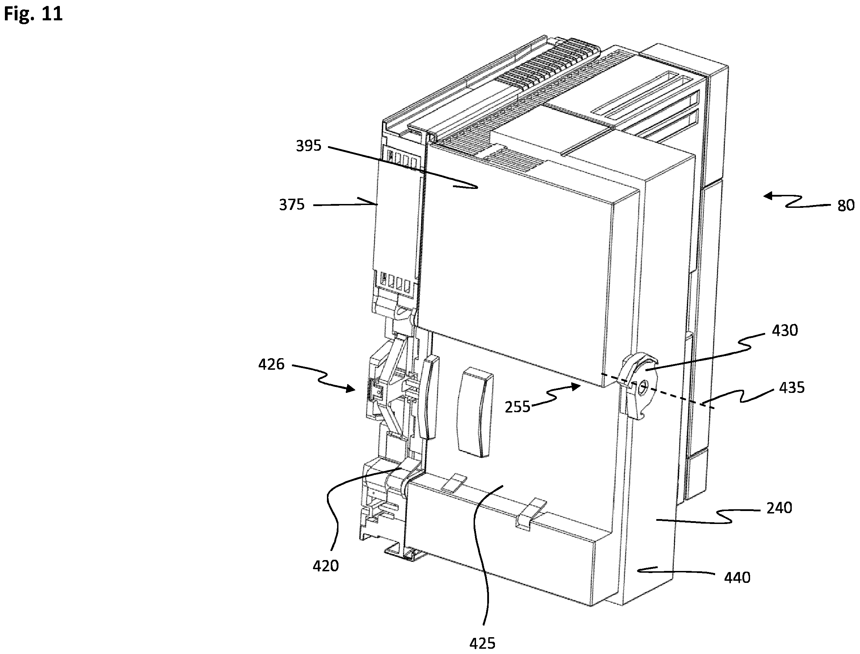

Figur 11 zeigt eine perspektivische Darstellung mit Blickrichtung von hinten nach vorne auf das in Figur 10 gezeigte Steuermodul 80.

Das dritte Verbindungsmittel 255 weist an der Steuergehäuserückseite 395 wenigstens eine balkenfederartig ausgebildete zweite Haltefeder 420 auf, die seitlich angrenzend an eine nutförmig ausgebildete zweite Aussparung 425 des Steuergehäuses 240 angeordnet ist. Die zweite Haltefeder 420 hintergreift in montiertem Zustand des Steuermoduls 80 an der Hutschiene 20 die Hutschiene 20 und befestigt dadurch formschlüssig das Steuergehäuse 240. Ferner kann in der zweiten Aussparung 425 ein V-förmig ausgestaltetes zweites Eingriffselement 426 angeordnet sein, das in montiertem Zustand in die Hutschiene 20 eingreift.

Zusätzlich kann das dritte Verriegelungsmittel 255 einen zweiten Drehknopf 430 aufweisen, der drehbar um eine zweite Drehachse 435 an einer zur ersten Steuergehäuseseitenfläche 375 gegenüberliegenden zweiten Steuergehäuseseitenfläche 440 angeordnet ist.

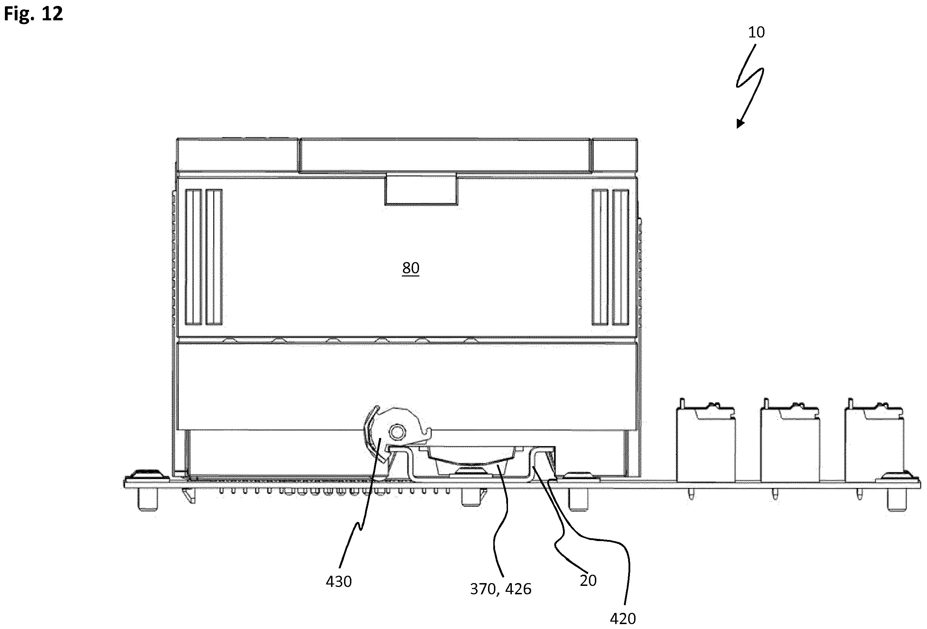

Figur 12 zeigt eine Seitenansicht auf das in Figur 5 gezeigte Steuerungssystem 10.

Die Funktion des zweiten Drehknopfs 430 entspricht der des ersten Drehknopfs 386, sodass der zweite Drehknopf 430 eine zweite Entriegelungs- und eine zweite Verriegelungsposition aufweist, wobei in der zweiten Entriegelungsposition das Steuermodul 80 auf die Hutschiene 20 aufsteckbar ist und in der zweiten Verriegelungsposition der zweite Drehknopf 430 die Hutschiene 20 bereichsweise hintergreift, sodass mittels des dritten Verbindungsmittels eine zerstörungsfreie, lösbare Verbindung des Steuermoduls 80 an der Hutschiene 20 bereitgestellt werden kann.

Durch die in Querrichtung gegenüberliegende Anordnung der ersten und zweiten Drehknöpfe 386, 430 und die Kopplung des ersten Koppelmoduls, des Klemmenmoduls 185 und des Steuermoduls 80 in der Baugruppe kann eine stabile Befestigung der gesamten Baugruppe an der Hutschiene 20 und an der Signalübertragungsplatte 15 erzielt und sichergestellt werden. Ferner wird eine gute Ausrichtung des Steuermoduls 80 und des ersten Koppelmoduls an der Hutschiene 20 durch das erste und zweite Eingriffselement ermöglicht.

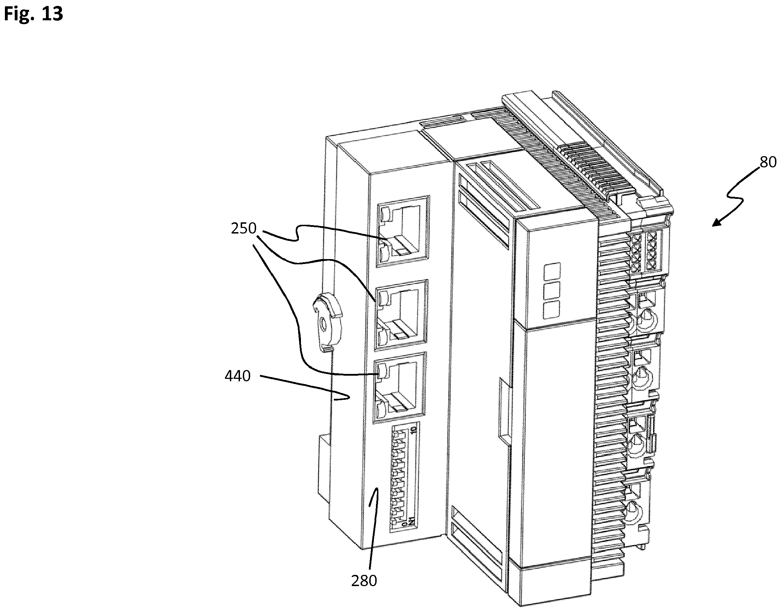

Figur 13 zeigt eine weitere perspektivische Darstellung mit Blickrichtung von vorne nach hinten auf das in den Figuren 10 bis 12 gezeigte Steuermodul 80.

Anschließend an die zweite Steuergehäuseseitenfläche 440 ist an der Steuergehäusevorderseite 280 der vierte Datenanschluss 250 angeordnet, der in der Ausführungsform beispielhaft als RJ45-Buchse ausgebildet ist. Vorzugsweise sind mehrere in Höhenrichtung nebeneinander angeordnete vierte Datenanschlüsse 250 vorgesehen, die beispielsweise dazu ausgebildet sind, das Steuermodul 80 mit einem Netzwerk, beispielsweise einem Netzwerk, das nach EtherCAT-Standard betrieben wird, zu verbinden.

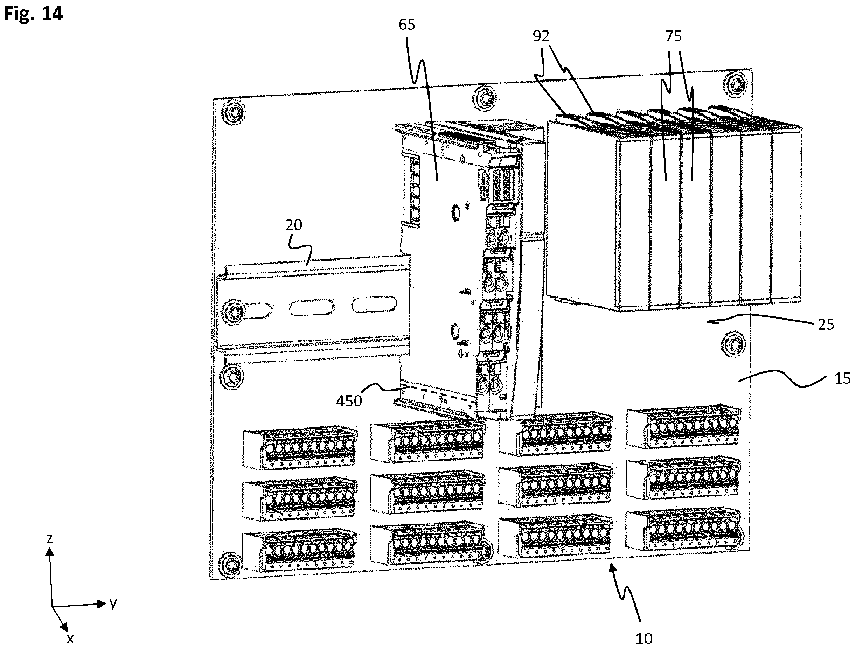

Figur 14 zeigt das in Figur 5 gezeigte Steuerungssystem 10 in einem teilmontieren Zustand nach einem dritten Verfahrensschritt.

In einem ersten Verfahrensschritt zur Montage des in Figur 5 gezeigten Steuerungssystems 10 wird die Signalübertragungsplatte 15 mit daran bereits befestigten ersten Kontakteinrichtungen 55 und der an der Signalübertragungsplatte 15 und der befestigten Hutschiene 20 bereitgestellt. Ferner werden das Steuermodul 80, das erste Kopplermodul 65 und gegebenenfalls Signalverarbeitungsmodule 75 als Einzelmodule bereitgestellt.

In einem auf den ersten Verfahrensschritt folgenden zweiten Verfahrensschritt werden die Signalverarbeitungsmodule 75 im zweiten Plattenbereich montiert, sodass die Signalverarbeitungsmodule 75 durch das Befestigungsmittel 92 formschlüssig mit der Signalübertragungsplatte 15 verbunden sind. Dabei kontaktieren die Signalverarbeitungsmodule 75 die zweite Kontakteinrichtung 60, sodass die Signalverarbeitungsmodule 75 elektrisch über die Signalübertragungsplatte 15 auch mit den ersten Kontakteinrichtungen 55 verbunden sind.

In einem auf den zweiten Verfahrensschritt folgenden dritten Verfahrensschritt wird das erste Kopplermodul 65 im ersten Plattenbereich montiert. Dabei wird das erste Kopplermodul 65 parallel zu einer Montageachse 450, die parallel zur x-Achse verläuft und senkrecht zur Plattenvorderseite 25 ausgerichtet ist, in einer ersten Montagebewegung auf die Hutschiene 20 aufgesteckt. Dabei befindet sich der erste Drehknopf 386 in der ersten Entriegelungsposition. Ferner wird die dritte Kontakteinrichtung 90 in die vierte Kontakteinrichtung 231 beim Aufstecken des ersten Kopplermoduls 65 auf die Hutschiene 20 eingesteckt. Durch die vierte Kontakteinrichtung 231 wird in Querrichtung die Position des ersten Kopplermoduls 65 an der Hutschiene 20 festgelegt.

Nach Aufstecken des ersten Kopplermoduls 65 wird der erste Drehknopf 386 in die erste Verriegelungsposition verdreht, sodass das das erste Kopplermodul 65 an der Hutschiene 20 gesichert ist.

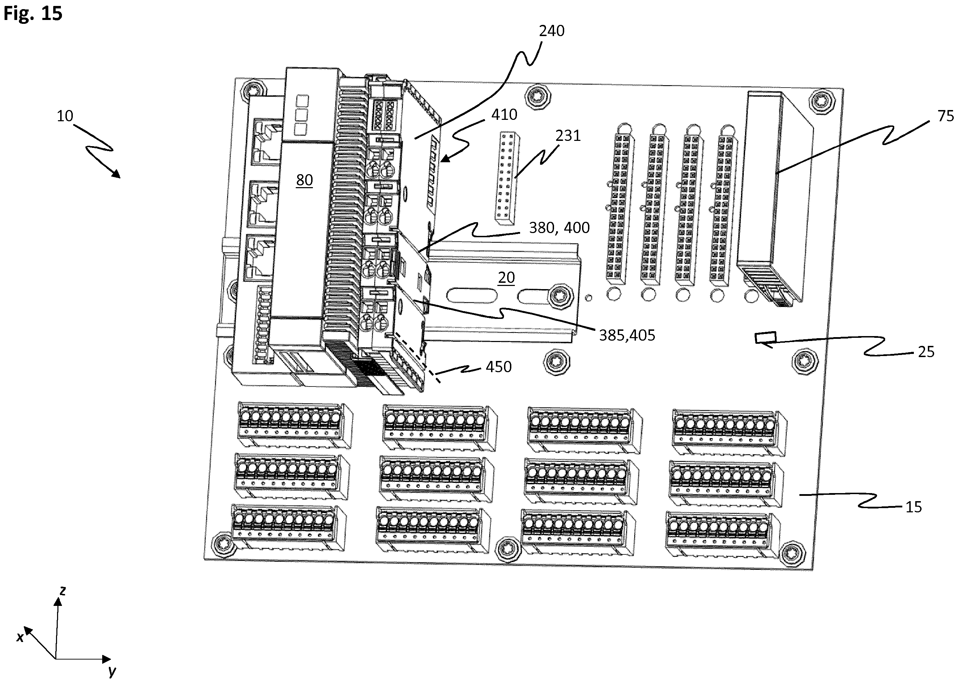

Figur 15 zeigt eine perspektivische Darstellung des in Figur 5 gezeigten Steuerungssystems 10 in einem teilmontieren Zustand nach einem vierten Verfahrensschritt. Dabei wird aus Übersichtlichkeitsgründen auf die Darstellung einiger Signalverarbeitungsmodule 75 und des ersten Kopplermoduls 65 verzichtet.

In einem auf den dritten Verfahrensschritt folgenden vierten Verfahrensschritt wird das Steuermodul 80 parallel zur Montageachse 450 in einer zweiten Montagebewegung auf die Hutschiene 20 aufgesteckt. Dabei greifen die ersten und zweiten Energieversorgungskontakte 325, 330 des ersten Kopplermoduls 65 in die ersten und zweiten Nuten 380, 385 des Steuermoduls 80 ein, sodass in der Montagebewegung die ersten und zweiten Energieversorgungskontakte 325, 330 des ersten Kopplermoduls 65 durch die ersten und zweiten Nuten 380, 385 des Steuermoduls 80 geführt werden und gleichzeitig die ersten und zweiten Energieversorgungskontakte 325, 330 des ersten Kopplermoduls 65 die ersten und zweiten Schlitzkontakte 400, 405 des Steuermoduls 80 kontaktieren. Ferner kontaktiert die erste Datenkontakteinrichtung 290 des ersten Kopplermoduls 65 die zweite Datenkontakteinrichtung 410 des Steuermoduls 80. Beim Aufstecken befindet sich der zweite Drehknopf 430 in der zweiten Entriegelungsposition. Nach Aufstecken des Steuermoduls 80 auf die Hutschiene 20 wird der zweite Drehknopf 380 in die zweite Verriegelungsposition um die zweite Drehachse 435 verdreht, sodass das Steuermodul 80 an der Hutschiene 20 gesichert ist. Ferner liegt rückseitig das Steuergehäuse 240 an der Plattenvorderseite 25 an, sodass eine Momentenübertragung vom Steuermodul 80 auf die Signalübertragungsplatte 15 reduziert ist. Dadurch kann die Signalübertragungsplatte 15 in x-Richtung besonders dünn ausgebildet sein.

Durch die Kontaktierung der ersten und zweiten Energieversorgungskontakte 325, 330 des ersten Kopplermoduls 65 über die ersten und zweiten Schlitzkontakte 400, 405 des Steuermoduls 80 wird eine zuverlässige Energieversorgung des ersten Kopplermoduls 65 bereitgestellt. Ferner kann auf den zusätzlichen Versorgungsanschluss 230, wie er beispielsweise in Figur 1 gezeigt ist, verzichtet werden.

Die in Figuren 5 bis 15 beschriebene Ausgestaltung hat den Vorteil, dass ein besonders kompaktes Steuerungssystem 10 mit einem als Hutschienen-PC ausgebildeten Steuermodul 80 bereitgestellt werden kann. Dadurch kann die Anzahl der an der Signalübertragungsplatte 15 angeordneten Module besonders gering gehalten werden, sodass zum einen der Bauraumbedarf des Steuerungssystems 10 besonders kompakt ist und zum anderen die Anzahl der Montageschritte gegenüber bekannten Steuerungssystemen reduziert ist.

Ferner kann mittels der dritten und vierten Kontakteinrichtung 90, 231 ein Datenaustausch direkt über die als applikationsspezifische Leiterplatte ausgebildete Signalübertragungsplatte 15 mit den Signalverarbeitungsmodulen 75 erfolgen. Durch die direkte Ankopplung des Steuermoduls 80 kann beispielsweise auf Verlängerungs(-koppel-)module verzichtet werden.

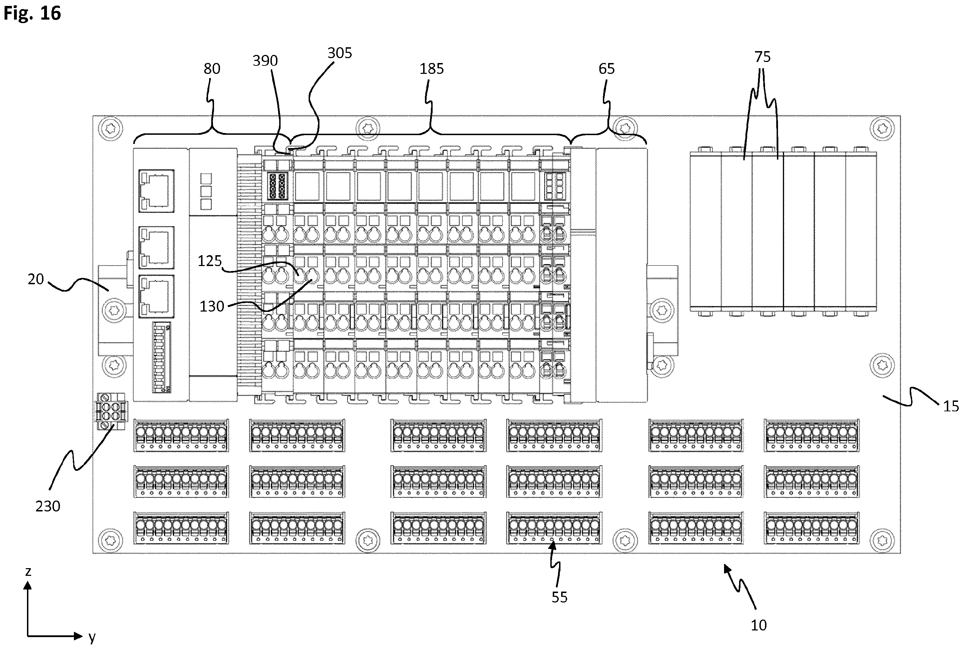

Figur 16 zeigt eine Vorderansicht auf ein Steuerungssystem 10 gemäß einer vierten Ausführungsform.

Das Steuerungssystem 10 ist im Wesentlichen eine Kombination aus dem in Figur 5 gezeigten Steuerungssystem mit den im Zusammenhang mit den Figuren 3 und 4 erläuterten Klemmenmodulen 185, wobei die Klemmenmodule 185 in Querrichtung zwischen dem ersten Kopplermodul 65 und dem Steuermodul 80 angeordnet sind. Die Anzahl der Klemmenmodule 185 ist beispielhaft. Ferner können die jeweiligen Feldanschlusskontakte 125, 130 dahingehend adaptiert sein, dass Klemmenmodule 185 bereitgestellt werden, die nicht beispielsweise mittels den Signalverarbeitungsmodulen 75 bereitgestellt werden können. Zur mechanischen Befestigung greift die Feder 390 in den Umgreifungsabschnitt 305 ein. Dabei umgreift der Umgreifungsabschnitt 305 jeweils das nächstliegende Gehäuse des Steuermoduls 80.

An jedem Klemmenmodul 185 ist linksseitig die erste Datenkontakteinrichtung 310 und rechtsseitig die zweite Datenkontakteinrichtung 410 angeordnet, sodass die Datenverbindung durch das Klemmenmodul 185 durchgeschleift ist, um so eine Datenverbindung zwischen Steuermodul 80 und dem ersten Kopplermodul 65 bereitzustellen. Ebenso sind am Klemmenmodul 185 linksseitig die Energieversorgungskontakte und rechtsseitig die Schlitzkontakte angeordnet, sodass die Energieversorgung vom Steuermodul 80 zum ersten Kopplermodul 65 durch das Klemmenmodul 185 geschleift ist. Ferner wird das Klemmenmodul 185 mit elektrischer Energie aus dem Steuermodul 80 versorgt.

Dadurch kann das Steuerungssystem 10 flexibel an das Automatisierungssystem angepasst werden und bei Bedarf entsprechend mittels der Klemmenmodule 185 erweitert werden.

Zusätzlich kann der in den Figuren 1 bis 3 erläuterte Versorgungsanschluss 230 auf der Signalübertragungsplatte 15 zur Versorgung der ersten Kontakteinrichtungen 55 und der Signalverarbeitungsmodule 75 angeordnet sein.

Des Weiteren ist gegenüber der in Figur 5 gezeigten Ausgestaltung des Steuerungssystem 10 die Anzahl der ersten Kontakteinrichtungen 55 erhöht, sodass eine größere Anzahl von Feldgeräten an dem Steuerungssystem 10 angeschlossen werden können.

Die Signalübertragungsplatte 15 ist in Querrichtung breiter als in Figur 3 gezeigt ausgebildet, sodass genügend Bauraum für eine verlängerte Hutschiene 20 auf der Signalübertragungsplatte 15 vorhanden ist. Dadurch kann eine besonders hohe Anzahl von Klemmenmodulen 185 zwischen dem Steuermodul 80 und dem ersten Kopplermodul 65 angeordnet werden.

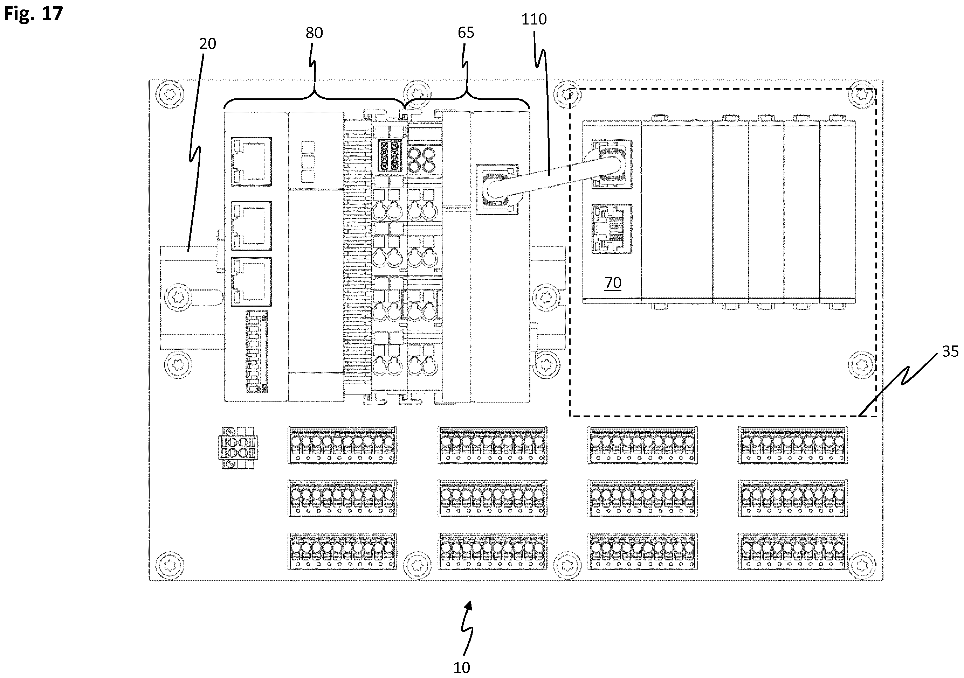

Figur 17 zeigt eine Vorderansicht auf ein Steuerungssystem 10 gemäß einer fünften Ausführungsform.

Das Steuerungssystem 10 ist im Wesentlichen eine Kombination aus dem in Zusammenhang mit Figur 5 erläuterten Steuerungssystem und dem in Zusammenhang mit den in den Figuren 1 bis 3 erläuterten Steuerungssystemen. Dabei ist auf der Hutschiene 20 das Steuermodul 80 anstatt des dritten Kopplermoduls befestigt, wobei rechtsseitig das in den Figuren 1 bis 3 erläuterte erste Kopplermodul 65 auf der Hutschiene 20 angeordnet ist. Das erste Kopplermodul 65 entspricht dem in den Figuren 1 bis 3 erläuterten ersten Kopplermodul 65 und ist mittels des ersten Datenkabels 110 mit dem zweiten Kopplermodul 70 verbunden, wobei das zweite Kopplermodul 70, wie in den Figuren 1 bis 3 erläutert, ausgebildet und im zweiten Plattenbereich 35 angeordnet ist. Das erste Kopplermodul 65 ist datentechnisch mit dem Steuermodul 80 verbunden und wird über das Netzgerät des Steuermoduls 80 versorgt.

Diese Ausgestaltung hat gegenüber der in den Figuren 1 bis 3 gezeigten Ausgestaltung den Vorteil, dass auf die separate Anordnung des Steuermoduls 80 und die Verbindung des Steuermoduls 80 über das zweite Datenkabel 220 verzichtet werden kann. Dadurch kann das Steuerungssystem 10 besonders kompakt ausgebildet sein.

Durch die Anordnung des Steuermoduls 80 auf der Hutschiene 20 kann das Steuerungssystem 10 vorab getestet werden und zu einem späteren Zeitpunkt optimal als gesamte Einheit in eine Montage des Automatisierungssystems eingebaut werden.

Zusammengefasst liegt gemäß einer Ausführungsform ein erfindungsgemäßes Steuerungssystem 10 vor, bei dem nur das auf der Hutschiene 20 montierte erste Kopplermodul 65 an der Gehäuserückseite 295 eine dritte Kontakteinrichtung 90 aufweist, die in montiertem Zustand die Durchkontaktierung der vierten Kontakteinrichtung 231 auf der Signalübertragungsplatte 15 durchgreift und dadurch eine elektrische Verbindung zwischen dem ersten Kopplermodul 65 und der Signalübertragungsplatte 15 erzielt, und bei dem das erste Kopplermodul 65 an einer ersten Gehäuseseitenfläche 115, die in montiertem Zustand senkrecht zu einer Plattenvorderseite 25 der Signalübertragungsplatte angeordnet ist, eine erste Datenkontakteinrichtung 290 und zumindest einen ersten und einen zweiten Energieversorgungskontakt 325, 330 aufweist, wohingegen alle weiteren auf der Hutschiene 20 montierten dritten Kopplermodule 180, Klemmenmodule 185 und/oder Steuermodule 80 lediglich an zumindest einer Ihrer Seitenflächen, die in montiertem Zustand senkrecht zu einer Plattenvorderseite 25 der Signalübertragungsplatte 15 angeordnet sind, erste und/oder zweite Datenkontakteinrichtungen 290, 410 und zumindest erste und zweite Schlitzkontakte 400, 405 aufweisen, wobei im montierten Zustand eine elektrische Verbindung zur Datenübertragung zwischen allen ersten und zweiten Datenkontakteinrichtungen 290, 410 und eine elektrische Verbindung zur Energieübertragung zwischen allen ersten Energieversorgungskontakten 325 und allen ersten Schlitzkontakten 400, bzw. eine elektrische Verbindung zur Energieübertragung zwischen allen zweiten Energieversorgungskontakten 330 und allen zweiten Schlitzkontakten 405 besteht, wobei die dritten Kopplermodule 180, Klemmenmodule 185 und/oder Steuermodule 80 gegebenenfalls zu einer der Plattenvorderseite 25 der Signalübertragungsplatte 15 abgewandten Vorderseite weitere Feldanschlüsse 120, erste und zweite Feldkontakte 125, 130, erste bis fünfte Einspeisekontakte 252, 253, 254, 140, 155 und/oder zweite bis vierte Datenanschlüsse 195, 200, 250 aufweisen, wohingegen die auf der Signalübertragungsplatte 15 angeordneten Signalverarbeitungsmodule 75 ausschließlich auf ihrer der Plattenvorderseite 25 der Signalübertragungsplatte 15 zugewandten Seite Kontakteinrichtungen aufweist, die im montierten Zustand mit auf der Signalübertragungsplatte 15 angeordneten zweiten Kontakteinrichtungen 60 eine elektrische Verbindung sowohl zur Datenübertragung als auch zur Energieübertragung ausbilden.

### Bezugszeichenliste

- 10: Steuerungssystem
- 15: Signalübertragungsplatte
- 16: Verbindungsschraube
- 17: Leiterplatte
- 18: Leiterplattenschicht
- 19: Leiterbahnlage
- 20: Hutschiene
- 25: Plattenvorderseite
- 30: erster Plattenbereich
- 35: zweiter Plattenbereich
- 40: dritter Plattenbereich
- 45: Schraubverbindung
- 55: erste Kontakteinrichtung
- 56: erste Reihe
- 57: untere Kante
- 60: zweite Kontakteinrichtung
- 65: erstes Kopplermodul
- 70: zweites Kopplermodul
- 75: Signalverarbeitungsmodul
- 80: Steuermodul
- 85: erstes Gehäuse
- 86: Kodiereinrichtung
- 90: dritte Kontakteinrichtung
- 91: Durchgangsöffnung
- 92: Befestigungsmittel
- 93: zweite Reihe
- 95: erstes Verbindungsmittel
- 100: erste Gehäusevorderseite
- 105: erster Stecker
- 110: erstes Datenkabel
- 115: erste Gehäuseseitenfläche
- 120: Feldanschluss
- 125: erster Feldkontakt
- 130: zweiter Feldkontakt
- 135: dritter Feldkontakt
- 140: vierter Feldkontakt
- 145: dritte Reihe
- 155: fünfter Feldkontakt
- 160: zweites Gehäuse
- 165: erster Datenanschluss
- 170: zweite Gehäusevorderseite
- 175: zweiter Stecker
- 180: drittes Kopplermodul
- 185: Anschlussmodul
- 190: drittes Gehäuse
- 195: zweiter Datenanschluss
- 200: dritter Datenanschluss
- 205: zweites Verbindungsmittel
- 210: dritte Gehäusevorderseite
- 215: dritter Stecker
- 220: zweites Datenkabel
- 230: Versorgungsanschluss
- 231: vierte Kontakteinrichtung
- 235: obere Plattenkante
- 240: Steuergehäuse
- 245: Steuereinrichtung
- 250: vierter Datenanschluss
- 251: Einspeiseanschluss
- 252: erster Einspeisekontakt
- 253: zweiter Einspeisekontakt
- 254: dritter Einspeisekontakt
- 255: drittes Verbindungsmittel
- 260: Recheneinrichtung
- 265: Datenspeicher
- 270: Schnittstelle
- 280: Steuergehäusevorderseite
- 285: Gehäuseoberseite
- 290: erste Datenkontakteinrichtung
- 295: Gehäuserückseite
- 300: Gehäuseunterseite
- 305: Umgreifungsabschnitt
- 310: erster Datenkontakt
- 315: Einbuchtung
- 320: Dummy-Feldanschluss
- 325: erster Energieversorgungskontakt
- 330: zweiter Energieversorgungskontakt
- 335: lange Seite
- 340: Rahmen
- 350: erstes Kontaktelement
- 355: zweites Kontaktelement
- 360: drittes Kontaktelement
- 365: erste Haltefeder
- 370: erstes Eingriffselement
- 371: zweite Gehäuseseitenfläche
- 375: erste Steuergehäuseseitenfläche
- 380: erste Nut
- 385: zweite Nut
- 386: erster Drehknopf
- 387: erste Drehachse
- 390: Feder
- 395: Steuergehäuserückseite
- 400: erster Schlitzkontakt
- 405: zweiter Schlitzkontakt
- 410: zweite Datenkontakteinrichtung
- 415: zweiter Datenkontakt
- 420: zweite Haltefeder
- 425: zweite Aussparung
- 426: zweites Eingriffselement
- 430: zweiter Drehknopf
- 435: zweite Drehachse
- 440: zweite Steuergehäuseseitenfläche
- 450: Montageachse

## Patentansprüche

1. Steuerungssystem (10) zur Steuerung eines Automatisierungssystems,
- aufweisend eine Signalübertragungsplatte (15), wenigstens eine erste Kontakteinrichtung (55) und wenigstens eine zweite Kontakteinrichtung (60),
- wobei die erste Kontakteinrichtung (55) und die zweite Kontakteinrichtung (60) an der Signalübertragungsplatte (15) versetzt zueinander angeordnet sind und die Signalübertragungsplatte (15) die erste Kontakteinrichtung (55) mit der zweiten Kontakteinrichtung (60) zur Übertragung zumindest von Daten elektrisch verbindet,
- wobei die zweite Kontakteinrichtung (60) ausgebildet ist, ein Signalverarbeitungsmodul (75) oder ein zweites Kopplermodul (70) elektrisch zu kontaktieren,
- wobei die erste Kontakteinrichtung (55) mit einem Feldgerät elektrisch verbindbar ist,
**gekennzeichnet durch**
- eine Hutschiene,
- wobei die Hutschiene (20) mechanisch an der Signalübertragungsplatte (15) befestigt ist und an der Hutschiene (20) ein erstes Kopplermodul (65) mechanisch befestigbar ist.

2. Steuerungssystem (10) nach Anspruch 1,
- wobei die Signalübertragungsplatte (15) eine Leiterplatte (17) umfasst,
- wobei die Leiterplatte (17) wenigstens eine Leiterplattenschicht (18) mit einem elektrisch isolierenden Material, vorzugsweise aus einem faserverstärkten Kunststoff, aufweist
- wobei die Leiterplatte (17) wenigstens eine auf der Leiterplattenschicht (18) angeordnete Leiterbahnlage (19) aus einem elektrisch leitfähigen Material aufweist,
- wobei die Leiterplattenschicht (18) ausgebildet ist, mechanische Kräfte aus der Hutschiene (20) abzustützen und die Leiterbahnlage (19) ausgebildet ist, elektrisch die erste Kontakteinrichtung (55) mit der zweiten Kontakteinrichtung (60) zu verbinden.

3. Steuerungssystem nach Anspruch 2,
- wobei die Leiterplatte (17) mehrere Leiterplattenschichten (18) aufweist,
- wobei zwischen den Leiterplattenschichten (18) jeweils eine Leiterbahnlage (19) aus einem elektrisch leitfähigen Material angeordnet ist,
- wobei die Leiterbahnlage (19) und die Leiterplattenschichten (18) abwechselnd in einem Stapel angeordnet sind.

4. Steuerungssystem (10) nach einem der vorhergehenden Ansprüche,
- aufweisend das erste Kopplermodul (65) mit einem ersten Gehäuse (85), einer dritten Kontakteinrichtung (90) und einem lösbaren ersten Verbindungsmittel (95),
- wobei an einer ersten Gehäuserückseite (295) des ersten Gehäuses (85) eine erste Aussparung (361) angeordnet ist, in die die Hutschiene (20) eingreift,
- wobei das erste Verbindungsmittel (95) mit dem ersten Gehäuse (85) verbunden und ausgebildet ist, zur zerstörungsfrei reversibel lösbaren Befestigung des Gehäuses (85) an der Hutschiene (20) in die Hutschiene (20) einzugreifen,
- wobei die dritte Kontakteinrichtung (90) an dem ersten Gehäuse (85) angeordnet und zur Datenübertragung ausgebildet ist.

5. Steuerungssystem nach Anspruch 4,
- wobei die dritte Kontakteinrichtung (90) an der ersten Gehäuserückseite (295) versetzt in einer Richtung senkrecht zu einer Längserstreckung der ersten Aussparung (361) zu dem ersten Verbindungsmittel (95) angeordnet ist.

6. Steuerungssystem (10) nach Anspruch 4 oder 5,
- wobei das erste Kopplermodul (65) an einer ersten Gehäuseseitenfläche (115) des ersten Gehäuses (85) eine erste Datenkontakteinrichtung (290) aufweist,
- wobei die erste Datenkontakteinrichtung (290) mit der dritten Kontakteinrichtung (90) zur Datenübertragung gekoppelt ist.

7. Steuerungssystem (10) nach Anspruch 6,
- wobei das Kopplermodul (65) an der ersten Gehäuseseitenfläche (115) wenigstens einen ersten Energieversorgungskontakt (325) und wenigstens einen zweiten Energieversorgungskontakt (330) aufweist,
- wobei der erste Energieversorgungskontakt (325) mit einem ersten Pol einer Gleichspannungsquelle und der zweite Energieversorgungskontakt (330) mit einem zweiten Pol der Gleichspannungsquelle direkt oder indirekt verbindbar ist,
- wobei der erste Energieversorgungskontakt (325) mit einem ersten Kontaktelement (350) der dritten Kontakteinrichtung (90) und der zweite Energieversorgungskontakt (330) mit einem zweiten Kontaktelement (360) der dritten Kontakteinrichtung (90) zur Übertragung von Versorgungsenergie elektrisch verbunden sind.

8. Steuerungssystem (10) nach Anspruch 7,
- wobei der erste Energieversorgungskontakt (325) und/oder der zweite Energieversorgungskontakt (330) plattenförmig ausgebildet ist und über die erste Gehäuseseitenfläche (115) herausragt,
- wobei der erste Energieversorgungskontakt (325) und/oder der zweite Energieversorgungskontakt (330) mit einer langen Seite senkrecht zur Gehäuserückseite (295) ausgerichtet ist,
und/oder
- wobei die dritte Kontakteinrichtung (90) wenigstens ein drittes Kontaktelement (355) aufweist,
- wobei zur Datenübertragung das dritte Kontaktelement (355) mit der ersten Datenkontakteinrichtung (290) gekoppelt sind.

9. Steuerungssystem (10) nach einem der vorhergehenden Ansprüche,
- wobei die Signalübertragungsplatte (15) auf einer Plattenvorderseite (25) einen ersten Plattenbereich (30), einen zweiten Plattenbereich (35) und einen dritten Plattenbereich (40) aufweist,
- wobei die ersten bis dritten Plattenbereiche (30, 35, 40) aneinander angrenzend angeordnet sind,
- wobei im ersten Plattenbereich (30) die Hutschiene (20) angeordnet ist,
- wobei im zweiten Plattenbereich (35) mehrere, vorzugsweise identisch zueinander ausgebildete, zweite Kontakteinrichtungen (60) angeordnet sind und
- wobei im dritten Plattenbereich (40) mehrere erste Kontakteinrichtungen (55) angeordnet sind, und/oder
- wobei das Steuerungssystem (10) eine an der Signalübertragungsplatte (15) angeordnete vierte Kontakteinrichtung (231) aufweist,
- wobei die Signalübertragungsplatte (15) zumindest zur Datenübertragung die vierte Kontakteinrichtung (231) mit der ersten Kontakteinrichtung (55) und/oder der zweiten Kontakteinrichtung (60) elektrisch verbindet,
- wobei die vierte Kontakteinrichtung (231) benachbart zu der Hutschiene (20) auf einer zur Hutschiene (20) zugewandten Plattenvorderseite (25) der Signalübertragungsplatte (15) angeordnet ist,
- wobei die dritte Kontakteinrichtung (90) auf einer zur Signalübertragungsplatte (15) zugewandten Gehäuserückseite des ersten Gehäuses (85) angeordnet ist und die dritte Kontakteinrichtung (90) des ersten Kopplermoduls (65) die vierte Kontakteinrichtung (231) elektrisch kontaktiert.

10. Steuerungssystem (10) nach einem der Ansprüche 4 bis 9,
- aufweisend das zweites Kopplermodul (70),
- wobei das zweite Kopplermodul (70) mittels eines Befestigungsmittels (92) mechanisch mit der Signalübertragungsplatte (15) verbunden ist,
- wobei das zweite Kopplermodul (70) elektrisch mit der dritten Kontakteinrichtung (90) des ersten Kopplermoduls (65) zur Datenübertragung, vorzugsweise mittels eines Datenkabels (110), verbunden ist.

11. Steuerungssystem (10) nach Anspruch 10,
- aufweisend einen an der Signalübertragungsplatte (15) angeordneten Energieversorgungsanschluss (230),
- wobei die Signalübertragungsplatte (15) elektrisch den Energieversorgungsanschluss (230) mit der zweiten Kontakteinrichtung (60) verbindet,
- wobei das zweite Kopplermodul (70) elektrisch die zweite Kontakteinrichtung (60) zur Datenübertragung und zur Energieversorgung des zweiten Kopplermoduls (70) kontaktiert.

12. Steuerungssystem (10) nach einem der vorhergehenden Ansprüche,
- aufweisend ein Steuermodul (80),
- wobei das Steuermodul (80) wenigstens eine Steuereinrichtung (245) zur Durchführung eines Steuerverfahrens, ein die Steuereinrichtung (245) aufnehmendes Steuergehäuse (240) und ein reversibel lösbares weiteres Verbindungsmittel (255) aufweist,
- wobei das Steuermodul (80) auf der Hutschiene (20) montiert ist,
- wobei das weitere Verbindungsmittel (255) mit dem Steuergehäuse (240) verbunden und ausgebildet ist, die Hutschiene (20) zur zerstörungsfrei lösbaren Befestigung des Steuergehäuses (240) an der Hutschiene (20) bereichsweise zu hintergreifen.

13. Steuerungssystem (10) nach Anspruch 12,
- wobei das Steuergehäuse (240) an einer der ersten Gehäuseseitenfläche (115) des ersten Gehäuses (85) zugewandten ersten Steuergehäuseseitenfläche (375) wenigstens eine erste Nut (380) aufweist und das Steuermodul (80) wenigstens einen in der ersten Nut (380) angeordneten Schlitzkontakt (400) aufweist,
- wobei die erste Nut (380) ausgebildet ist, den ersten Energieversorgungskontakt (325) des ersten Kopplermoduls (65) in der Montagebewegung des ersten Kopplermoduls (65) zu führen,
- wobei der erste Schlitzkontakt (400) den ersten Energieversorgungskontakt (325) zur Energieversorgung des ersten Kopplermoduls (65) kontaktiert.

14. Steuerungssystem (10) nach Anspruch 13,
- wobei das Steuergehäuse (240) an der ersten Steuergehäuseseitenfläche (375) wenigstens eine zur ersten Nut (380) versetzt angeordnete zweite Nut (385) aufweist,
- wobei vorzugsweise die erste Nut (380) und die zweite Nut (385) senkrecht zur Signalübertragungsplatte (15) und in einem vordefinierten Abstand zueinander angeordnet sind,
- wobei der vordefinierte Abstand im Wesentlichen einem Abstand zwischen dem ersten Energieversorgungskontakt (325) und dem zweiten Energieversorgungskontakt (330) entspricht,
und/oder
- wobei das Steuermodul (80) an der ersten Steuergehäuseseitenfläche (375) eine zweite Datenkontakteinrichtung (410) aufweist,
- wobei die zweite Datenkontakteinrichtung (410) korrespondierend zu der ersten Datenkontakteinrichtung (290) des ersten Kopplermoduls (65) ausgebildet und mit der ersten Datenkontakteinrichtung (290) elektrisch zur Datenübertragung verbunden ist,
- wobei die zweite Datenkontakteinrichtung (410) elektrisch mit der Steuereinrichtung (245) zur Verarbeitung von mittels der ersten und zweiten Datenkontakteinrichtungen (290, 410) übertragbaren Daten verbunden ist,
und/oder
- wobei das Steuermodul (80) auf einer zur Signalübertragungsplatte (15) abgewandten Steuergehäusevorderseite (280) des Steuergehäuses (240) wenigstens einen Einspeiseanschluss (251) mit wenigstens einem ersten Einspeisekontakt (252) aufweist,
- wobei der erste Einspeisekontakt (252) mit einer Energieversorgung elektrisch verbindbar ist,
- wobei der erste Schlitzkontakt (400) mit dem ersten Einspeisekontakt (252) elektrisch verbunden ist.

15. Verfahren zur Montage eines Steuerungssystems (10) nach einem der vorhergehenden Ansprüche und Anspruch 4,
- wobei die Signalübertragungsplatte (15), das erste Kopplermodul (65) und das Steuermodul (80) bereitgestellt werden,
- wobei das erste Kopplermodul (65) in einer ersten Montagebewegung vorzugsweise senkrecht zur Signalübertragungsplatte (15) auf die Hutschiene (20) montiert wird und das erste Verbindungsmittel (95) das erste Kopplermodul (65) formschlüssig mit der Hutschiene (20) verbindet, wobei das Steuermodul (80) in einer zweiten Montagebewegung, vorzugsweise senkrecht zur Signalübertragungsplatte (15), auf die Hutschiene (20) montiert wird und das weitere Verbindungsmittel (255) das Steuergehäuse (240) mit der Hutschiene (20) formschlüssig verbindet.

## Claims

1. A control system (10) for controlling an automation system,
- comprising a signal-distribution board (15), at least a first contact device (55) and at least a second contact device (60),
- wherein the first contact device (55) and the second contact device (60) are arranged at an offset with regard to each other on the signal-distribution board (15) and the signal-distribution board (15) electrically connects the first contact device (55) to the second contact device (60) at least for transmitting data,
- wherein the second contact device (60) is embodied to electrically contact a signal-processing module (75) or a second coupling module (70),
- wherein the first contact device (55) may be electrically connected to a field device,
**characterized by**
- a top-hat rail,
- wherein the top-hat rail (20) is mechanically fastened to the signal-distribution board (15) and a first coupling module (65) may be mechanically fastened to the top-hat rail (20).

2. The control system (10) according to claim 1,
- wherein the signal-distribution board (15) comprises a printed-circuit board (17),
- wherein the printed-circuit board (17) has at least one printed-circuit-board layer (18) having an electrically insulating material, preferably made of a fiber-reinforced plastic,
- wherein the printed-circuit board (17) comprises at least one conductor-path layer (19) of an electrically conductive material arranged on the printed-circuit-board layer (18),
- wherein the printed-circuit-board layer (18) is embodied to support mechanical forces from the top-hat rail (20) and the conductor-path layer (19) is embodied to electrically connect the first contact device (55) to the second contact device (60).

3. The control system according to claim 2,
- wherein the printed-circuit board (17) comprises a plurality of printed-circuit board layers (18),
- wherein between each of the printed-circuit-board layers (18) a conductor-path layer (19) made from an electrically conductive material is arranged,
- wherein the conductor-path layer (19) and the printed-circuit-board layers (18) are alternatingly arranged in a stack.

4. The a control system (10) according to any one of the preceding claims,
- comprising the first coupling module (65) having a first housing (85), a third contact device (90) and a detachable first connecting means (95),
- wherein a first recess (361) in which the top-hat rail (20) engages is arranged on a first housing-rear face (295) of the first housing (85),
- wherein the first connecting means (95) is connected to the first housing (85) and is embodied to engage in the top-hat rail (20) for non-destructively reversibly detachable fastening of the housing (85) at the top-hat rail (20),
- wherein the third contact device (90) is arranged at the first housing (85) and is embodied for transmitting data.

5. The control system according to claim 4,
- wherein the third contact device (90) is arranged on the first housing-rear face (295) at an offset in a direction perpendicular to a longitudinal extension of the first recess (361) with regard to the first connecting means (95) .

6. The control system (10) according to claim 4 or 5,
- wherein the first coupling module (65) comprises a first data-contact device (290) at a first housing-side face (115) of the first housing (85),
- wherein the first data-contact device (290) is coupled to the third contact device (90) for transmitting data.

7. The control system (10) according to claim 6,
- wherein the coupling module (65) comprises at least a first power-supply contact (325) and at least a second power-supply contact (330) at the first housing-side face (115),
- wherein the first power-supply contact (325) may be directly or indirectly connected to a first pole of a DC-voltage source and the second power-supply contact (330) may be directly or indirectly connected to a second pole of the DC-voltage source,
- wherein the first power-supply contact (325) is electrically connected to a first contact element (350) of the third contact device (90) and the second power-supply contact (330) is electrically connected to a second contact element (360) of the third contact device (90) for transmitting supply power.

8. The control system (10) according to claim 7,
- wherein the first power-supply contact (325) and/or the second power-supply contact (330) has a board-shaped embodiment and protrudes over the first housing-side face (115),
- wherein the first power-supply contact (325) and/or the second power-supply contact (330) is aligned with a long side perpendicular to the rear face (295) of the housing, and/or
- wherein the third contact device (90) comprises at least one third contact element (355),
- wherein the third contact element (355) is coupled to the first data-contact device (290) for transmitting data.

9. The control system (10) according to one of the preceding claims,
- wherein the signal-distribution board (15) comprises a first board area (30), a second board area (35) and a third board area (40) on a board-front side (25),
- wherein the first to third board areas (30, 35, 40) are arranged adjacent to one another,
- wherein the top-hat rail (20) is arranged in the first board area (30),
- wherein a plurality of second contact devices (60), which are preferably embodied identically to one another, are arranged in the second board region (35), and
- wherein a plurality of first contact devices (55) are arranged in the third board region (40),
and/or
- wherein the control system (10) comprises a fourth contact device (231) arranged at the signal-distribution board (15),
- wherein the signal-distribution board (15) electrically connects the fourth contact device (231) to the first contact device (55) and/or to the second contact device (60) at least for transmitting data,
- wherein the fourth contact device (231) is arranged adjacent to the top-hat rail (20) on a board-front side (25) of the signal-distribution board (15) facing the top-hat rail (20),
- wherein the third contact device (90) is arranged on a housing-rear face of the first housing (85) facing the signal-distribution board (15) and the third contact device (90) of the first coupling module (65) electrically contacts the fourth contact device (231).

10. The control system (10) according to any one of claims 4 to 9,
- comprising the second coupling module (70),
- wherein the second coupling module (70) is mechanically connected to the signal-distribution board (15) by means of a fastening means (92),
- wherein the second coupling module (70) is electrically connected to the third contact device (90) of the first coupling module (65) for transmitting data, preferably by means of a data cable (110).

11. The control system (10) according to claim 10,
- comprising a power-supply connection (230) arranged at the signal-distribution board (15),
- wherein the signal-distribution board (15) electrically connects the power-supply connection (230) to the second contact device (60),
- wherein the second coupling module (70) electrically contacts the second contact device (60) for transmitting data and for supplying power to the second coupling module (70) .

12. The control system (10) according to any of the preceding claims,
- comprising a control module (80),
- wherein the control module (80) comprises at least a control device (245) for carrying out a control process, a control housing (240) accommodating the control device (245) and a reversibly detachable further connecting means (255),
- wherein the control module (80) is mounted on the top-hat rail (20),
- wherein the further connecting means (255) is connected to the control housing (240) and embodied to engage behind the top-hat rail (20) in regions for non-destructively detachable fastening of the control housing (240) to the top-hat rail (20).

13. The control system (10) according to claim 12,
- wherein the control housing (240) comprises at least a first groove (380) at a first control-housing-side face (375) facing the first housing-side face (115) of the first housing (85) and the control module (80) has at least a slot contact (400) arranged in the first groove (380),
- wherein the first groove (380) is adapted to guide the first power-supply contact (325) of the first coupling module (65) in the mounting movement of the first coupling module (65),
- wherein the first slot contact (400) contacts the first power-supply contact (325) for supplying power to the first coupling module (65).

14. The control system (10) according to claim 13,
- wherein the control housing (240) comprises, on the first control-housing-side face (375), at least a second groove (385) arranged at an offset with regard to the first groove (380),
- wherein the first groove (380) and the second groove (385) are preferably arranged perpendicularly to the signal-distribution board (15) and at a predefined distance from each other,
- wherein the predefined distance essentially corresponds to a distance between the first power-supply contact (325) and the second power-supply contact (330),
- and/or
- wherein the control module (80) has a second data-contact device (410) at the first control-housing-side face (375),
- wherein the second data-contact device (410) is formed corresponding to the first data-contact device (290) of the first coupling module (65) and is electrically connected to the first data-contact device (290) for transmitting data,
- wherein the second data-contact device (410) is electrically connected to the control device (245) for processing data which may be transmitted by means of the first and second data-contact devices (290, 410), and/or
- wherein the control module (80) has at least one feed connection (251) with at least one first feed contact (252) on a control housing-front face (280) of the control housing (240) facing away from the signal-distribution board (15),
- wherein the first feed contact (252) may be electrically connected to a power supply,
- wherein the first slot contact (400) is electrically connected to the first feed contact (252).

15. A method of mounting a control system (10) according to any one of the preceding claims and claim 4,
- wherein the signal-distribution board (15), the first coupling module (65) and the control module (80) are provided,
- wherein the first coupling module (65) is mounted on the top-hat rail (20) in a first mounting movement preferably perpendicular to the signal-distribution board (15), and the first connecting means (95) connects the first coupling module (65) to the top-hat rail (20) in a form fit, wherein the control module (80) is mounted on the top-hat rail (20) in a second mounting movement preferably perpendicular to the signal-distribution board (15) and the further connecting means (255) connects the control housing (240) to the top-hat rail (20) in a form fit.

## Revendications

1. Système de commande (10) permettant de commander un système d'automatisation,
- présentant une carte de transmission de signal (15), au moins un premier dispositif de contact (55) et au moins un deuxième dispositif de contact (60),
- dans lequel le premier dispositif de contact (55) et le deuxième dispositif de contact (60) sont disposés de manière décalée l'un par rapport à l'autre sur la carte de transmission de signal (15), et la carte de transmission de signal (15) relie électriquement le premier dispositif de contact (55) au deuxième dispositif de contact (60) pour transmettre au moins des données,
- le deuxième dispositif de contact (60) étant réalisé pour entrer en contact électrique avec un module de traitement de signal (75) ou un deuxième module de couplage (70),
- le premier dispositif de contact (55) pouvant être relié électriquement à un appareil de terrain, **caractérisé par**
- un profilé chapeau,
- dans lequel le profilé chapeau (20) est fixé mécaniquement à la carte de transmission de signal (15), et un premier module de couplage (65) peut être fixé mécaniquement au profilé chapeau (20).

2. Système de commande (10) selon la revendication 1,
- la carte de transmission de signal (15) comprenant une carte de circuits imprimés (17),
- la carte de circuits imprimés (17) présentant au moins une couche de carte de circuits imprimés (18) d'un matériau électriquement isolant, de préférence en matière plastique renforcée fibres,
- la carte de circuits imprimés (17) présentant au moins une couche de pistes conductives (19) en matériau électriquement conducteur, disposée sur la couche de carte de circuits imprimés (18),
- dans lequel la couche de carte de circuits imprimés (18) est réalisée pour supporter des forces mécaniques provenant du profilé chapeau (20), et la couche de pistes conductives (19) est réalisée pour relier électriquement le premier dispositif de contact (55) au deuxième dispositif de contact (60).

3. Système de commande selon la revendication 2,
- dans lequel la carte de circuits imprimés (17) présente plusieurs couches de carte de circuits imprimés (18),
- respectivement une couche de pistes conductives (19) en matériau électriquement conducteur étant disposée entre les couches de carte de circuits imprimés (18),
- les couches de pistes conductives (19) et les couches de carte de circuits imprimés (18) étant empilées en alternance.

4. Système de commande (10) selon l'une quelconque des revendications précédentes,
- présentant le premier module de couplage (65) doté d'un premier boîtier (85), d'un troisième dispositif de contact (90) et d'un premier moyen de liaison amovible (95),
- dans lequel, sur une première face arrière de boîtier (295) du premier boîtier (85), un premier évidement (361) est disposé dans lequel le profilé chapeau (20) vient en prise,
- le premier moyen de liaison (95) étant relié au premier boîtier (85) et étant réalisé pour venir en prise dans le profilé chapeau (20) en vue de la fixation amovible et réversible sans destruction du boîtier (85) au profilé chapeau (20),
- le troisième dispositif de contact (90) étant disposé sur le premier boîtier (85) et étant réalisé pour la transmission de données.

5. Système de commande selon la revendication 4,
- dans lequel le troisième dispositif de contact (90) est disposé sur la première face arrière de boîtier (295) de manière décalée dans une direction perpendiculaire à une dimension longitudinale du premier évidement (361) par rapport au premier moyen de liaison (95).

6. Système de commande (10) selon la revendication 4 ou 5,
- dans lequel le premier module de couplage (65) présente sur une première face latérale de boîtier (115) du premier boîtier (85) un premier dispositif de contact de données (290),
- le premier dispositif de contact de données (290) étant couplé au troisième dispositif de contact (90) pour la transmission de données.

7. Système de commande (10) selon la revendication 6,
- dans lequel le module de couplage (65) présente sur la première face latérale de boîtier (115) au moins un premier contact d'alimentation en énergie (325) et au moins un deuxième contact d'alimentation en énergie (330),
- le premier contact d'alimentation en énergie (325) pouvant être relié directement ou indirectement à un premier pôle d'une source de tension continue et le deuxième contact d'alimentation en énergie (330) pouvant être relié directement ou indirectement à un deuxième pôle de la source de tension continue,
- le premier contact d'alimentation en énergie (325) étant relié électriquement au premier élément de contact (350) du troisième dispositif de contact (90), et le deuxième contact d'alimentation en énergie (330) étant relié électriquement à un deuxième élément de contact (360) du troisième dispositif de contact (90) pour la transmission d'énergie d'alimentation.

8. Système de commande (10) selon la revendication 7,
- dans lequel le premier contact d'alimentation en énergie (325) et/ou le deuxième contact d'alimentation en énergie (330) sont réalisés sous forme de plaquette et dépassent de la première face latérale de boîtier (115),
- le premier contact d'alimentation en énergie (325) et/ou le deuxième contact d'alimentation en énergie (330) étant orientés par un côté long perpendiculairement à la face arrière de boîtier (295), et/ou
- le troisième dispositif de contact (90) présentant au moins un troisième élément de contact (355),
- dans lequel, pour la transmission de données, le troisième élément de contact (355) est couplé au premier dispositif de contact de données (290).

9. Système de commande (10) selon l'une quelconque des revendications précédentes,
- dans lequel la carte de transmission de signal (15) présente sur une face avant de carte (25) une première zone de carte (30), une deuxième zone de carte (35) et une troisième zone de carte (40),
- les première à troisième zones de carte (30, 35, 40) étant disposées côte à côte,
- le profilé chapeau (20) étant disposé dans la première zone de carte (30),
- plusieurs deuxièmes dispositifs de contact (60), de préférence réalisés de manière identique entre eux, étant disposés dans la deuxième zone de carte (35), et
- plusieurs premiers dispositifs de contact (55) étant disposés dans la troisième zone de carte (40), et/ou
- le système de commande (10) présentant un quatrième dispositif de contact (231) disposé sur la carte de transmission de signal (15),
- la carte de transmission de signal (15) reliant électriquement au moins pour la transmission de données le quatrième dispositif de contact (231) au premier dispositif de contact (55) et/ou au deuxième dispositif de contact (60),
- le quatrième dispositif de contact (231) étant disposé à côté du profilé chapeau (20) sur une face avant de carte (25), orientée vers le profilé chapeau (20), de la carte de transmission de signal (15),
- dans lequel le troisième dispositif de contact (90) est disposé sur une face arrière de boîtier, tournée vers la carte de transmission de signal (15), du premier boîtier (85), et le troisième dispositif de contact (90) du premier module de couplage (65) entre en contact électrique avec le quatrième dispositif de contact (231).

10. Système de commande (10) selon l'une quelconque des revendications 4 à 9,
- présentant le deuxième module de couplage (70),
- le deuxième module de couplage (70) étant relié mécaniquement à la carte de transmission de signal (15) à l'aide d'un moyen de fixation (92),
- le deuxième module de couplage (70) étant relié électriquement au troisième dispositif de contact (90) du premier module de couplage (65) pour la transmission de données, de préférence au moyen d'un câble de données (110).

11. Système de commande (10) selon la revendication 10,
- présentant une borne d'alimentation en énergie (230) disposée sur la carte de transmission de signal (15),
- la carte de transmission de signal (15) reliant électriquement la borne d'alimentation en énergie (230) au deuxième dispositif de contact (60),
- le deuxième module de couplage (70) entrant en contact électrique avec le deuxième dispositif de contact (60) pour la transmission de données et pour l'alimentation en énergie du deuxième module de couplage (70).

12. Système de commande (10) selon l'une quelconque des revendications précédentes,
- présentant un module de commande (80),
- le module de commande (80) présentant au moins un dispositif de commande (245) pour exécuter un procédé de commande, un boîtier de connecteur (240) recevant le dispositif de commande (245), et un autre moyen de liaison (255) amovible de manière réversible,
- le module de commande (80) étant monté sur le profilé chapeau (20),
- l'autre moyen de liaison (255) étant relié au boîtier de commande (240) et étant réalisé pour saisir par l'arrière par endroits le profilé chapeau (20) en vue d'une fixation amovible sans destruction du boîtier de commande (240) au profilé chapeau (20).

13. Système de commande (10) selon la revendication 12,
- dans lequel le boîtier de commande (240) présente sur une première face latérale de boîtier de commande (375), tournée vers la première face latérale de boîtier (115) du premier boîtier (85), au moins une première rainure (380), et le module de commande (80) présente au moins un contact à fente (400) disposé dans la première rainure (380),
- la première rainure (380) étant réalisée pour guider le premier contact d'alimentation en énergie (325) du premier module de couplage (65) lors du mouvement de montage du premier module de couplage (65),
- le premier contact à fente (400) entrant en contact avec le premier contact d'alimentation en énergie (325) pour l'alimentation en énergie du premier module de couplage (65).

14. Système de commande (10) selon la revendication 13,
- dans lequel le boîtier de commande (240) présente sur la première face latérale de boîtier de commande (375) au moins une deuxième rainure (385) disposée de manière décalée par rapport à la première rainure (380),
- la première rainure (380) et la deuxième rainure (385) étant de préférence disposées perpendiculairement à la carte de transmission de signal (15) et à une distance prédéfinie l'une par rapport à l'autre,
- la distance prédéfinie correspondant substantiellement à une distance entre le premier contact d'alimentation en énergie (325) et le deuxième contact d'alimentation en énergie (330), et/ou
- le module de commande (80) présentant un deuxième dispositif de contact de données (410) sur la première face latérale de boîtier de commande (375),
- dans lequel le deuxième dispositif de contact de données (410) est réalisé de manière correspondante au premier dispositif de contact de données (290) du premier module de couplage (65) et est relié électriquement au premier dispositif de contact de données (290) pour la transmission de données,
- le deuxième dispositif de contact de données (410) étant relié électriquement au dispositif de commande (245) pour traiter des données transmissibles au moyen du premier et du deuxième dispositif de contact de données (290, 410), et/ou
- le module de commande (80) présentant sur une face avant de boîtier de commande (280), détournée de la carte de transmission de signal (15), du boîtier de commande (240) au moins une borne d'arrivée (251) dotée d'au moins un premier contact d'arrivée (252),
- le premier contact d'arrivée (252) pouvant être relié électriquement à une alimentation en énergie,
- le premier contact à fente (400) étant relié électriquement au premier contact d'arrivée (252).

15. Procédé de montage d'un système de commande (10) selon l'une quelconque des revendications précédentes et selon la revendication 4,
- dans lequel la carte de transmission de signal (15), le premier module de couplage (65) et le module de commande (80) sont fournis,
- le premier module de couplage (65) étant monté lors d'un premier mouvement de montage de préférence perpendiculairement à la carte de transmission de signal (15) sur le profilé chapeau (20), et le premier moyen de liaison (95) reliant le premier module de couplage (65) au profilé chapeau (20) par complémentarité de forme, dans lequel, lors d'un deuxième mouvement de montage, le module de commande (80) est monté, de préférence perpendiculairement à la carte de transmission de signal (15), sur le profilé chapeau (20), et l'autre moyen de liaison (255) relie le boîtier de commande (240) au profilé chapeau (20) par complémentarité de forme.
